# EUROPEAN PATENT APPLICATION

(11) **EP 4 340 027 A1**
(43) Date of publication of application: **20.03.2024**
(21) Application number: 22807745.9
(22) Date of filing: 09.05.2022
(51) Int. Cl.: H01L 27/12, H01L 27/15, H01L 25/075

(54) **DISPLAY DEVICE**

(30) Priority: 10.05.2021 KR 20210059876
(71) Applicant: Samsung Display Co., Ltd., Yongin-si, Gyeonggi-do 17113 (KR)
(72) Inventor: LEE, Hyun Wook, Suwon-si Gyeonggi-do 16332 (KR); VEIDHES, Basrur, Yongin-si Gyeonggi-do 17103 (KR); LEE, Jong Chan, Suwon-si Gyeonggi-do 16532 (KR); JO, Sung Won, Seoul 07225 (KR); HONG, Jung Eun, Seoul 08830 (KR)
(74) Representative: Marks & Clerk LLP
(86) International application number: PCT/KR2022/006569
(87) International publication number: WO 2022/240097

(57) **Abstract**

A display device is provided. The display device comprises: a conductive layer including a conductive pattern disposed on a first substrate and voltage wiring; a via layer disposed on the conductive layer and including contact holes exposing a portion of the conductive layer; a first electrode and a second electrode spaced apart from each other on the via layer; a first insulating layer disposed on the first electrode and the second electrode and including openings exposing the contact holes; light emitting elements disposed on the first electrode and the second electrode on the first insulating layer; and a first connection electrode disposed on the first electrode and in contact with the light emitting elements, and a second connection electrode disposed on the second electrode and in contact with the light emitting elements, wherein the first connection electrode is in direct contact with the conductive pattern through a first opening exposing a first contact hole, and the second connection electrode is in direct contact with the voltage wiring through a second opening exposing a second contact hole.

## Description

### [TECHNICAL FIELD]

The disclosure relates to a display device including the same.

### [BACKGROUND ART]

Display devices are becoming more important with developments in multimedia technology. Accordingly, various display devices such as an organic light-emitting diode (OLED) display device, a liquid crystal display (LCD) device, and the like have been used.

A typical display device includes a display panel such as an organic light-emitting display panel or a liquid crystal display (LCD) panel. A light-emitting display panel may include light-emitting elements. For example, light-emitting diodes (LEDs) include organic light-emitting diodes (OLEDs) using an organic material as a fluorescent material and inorganic LEDs using an inorganic material as a fluorescent material.

### [DISCLOSURE]

### [TECHNICAL PROBLEM]

Aspects of the disclosure provide a display device having a novel structure in connection between electrodes.

It should be noted that aspects of the disclosure are not limited to the above-mentioned aspects, and other unmentioned aspects of the disclosure will be clearly understood by those skilled in the art from the following descriptions.

### [TECHNICAL SOLUTION]

According to an embodiment of the disclosure, a display device includes a conductive layer including a voltage line and a conductive pattern on a substrate, a via layer on the conductive layer and including a plurality of contact holes exposing a portion of the conductive layer, a first electrode and a second electrode spaced from each other on the via layer, a first insulating layer on the first electrode and the second electrode and including a plurality of openings exposing the plurality of contact holes, light emitting elements on the first electrode and the second electrode on the first insulating layer, and a first connection electrode on the first electrode and in contact with the light emitting element, and a second connection electrode on the second electrode and in contact with the light emitting element, wherein the first connection electrode is in direct contact with the conductive pattern through a first opening exposing a first contact hole of the plurality of contact holes, and the second connection electrode is in direct contact with the voltage line through a second opening exposing the second contact hole of the plurality of contact holes.

The display device may further include a first dummy pattern spaced from the first electrode with the first contact hole interposed therebetween, and a second dummy pattern spaced from the second electrode with the second contact hole interposed therebetween, wherein a portion of the first insulating layer may be on the first dummy pattern and the second dummy pattern.

The first electrode and the second electrode may be spaced from the first dummy pattern and the second dummy pattern in one direction, respectively, and one sides of the first electrode and the second electrode facing the first dummy pattern and the second dummy pattern may be spaced from one side in the one direction of the openings more inward than the first insulating layer.

A first width of the first electrode and the second electrode measured in one direction may be smaller than a second width of the first opening and the second opening measured in the one direction.

The first connection electrode may include a first contact portion having a width measured in the one direction greater than the first width and located on the first contact hole, and the second connection electrode may include a second contact portion having a width measured in the one direction greater than the first width and located on the second contact hole.

The first contact portion and the second contact portion may be directly on the via layer around the first contact hole and the second contact hole, respectively.

A width of each of the first contact portion and the second contact portion measured in the one direction may be greater than the second width.

The display device may further include a bank layer around an emission area in which the light emitting elements are located on the first insulating layer, and a sub-region at one side of the emission area, wherein the first contact hole and the second contact hole may be in the sub-region, and each of the first connection electrode and the second connection electrode may be located over the emission area and the sub-region.

The first insulating layer may further include a separation portion in the sub-region and exposes a top surface of the via layer.

The display device may further include a second insulating layer on the light emitting elements without covering both sides of the light emitting elements.

The display device may further include a third insulating layer between the second insulating layer and the light emitting element, wherein both sides of the third insulating layer may be parallel to both sides of the second insulating layer.

The conductive layer may include a first layer, a second layer on the first layer and including a material different from the first layer, a third layer on the second layer and including a same material as the first layer, and a fourth layer on the third layer.

The fourth layer may include a same material as the first and second connection electrodes.

According to an embodiment of the disclosure, a display device includes an emission area and a sub-region at one side of the emission area in a first direction, first and second electrodes extending in the first direction and spaced from each other in a second direction, the first and second electrodes being in the emission area and the sub-region, a first insulating layer on the first electrode and the second electrode and including a plurality of openings in the sub-region, a plurality of light emitting elements on the first electrode and the second electrode in the emission area, a first connection electrode on the first electrode in the emission area and the sub-region and in contact with the light emitting element, and a second connection electrode on the second electrode in the emission area and the sub-region and in contact with the light emitting element, wherein the first connection electrode includes a first contact portion on a first contact hole exposed in a first opening of the first insulating layer, and the second connection electrode includes a second contact portion on a second contact hole exposed in a second opening of the first insulating layer.

The display device may further include a first dummy pattern spaced from the first electrode in the first direction with the first opening interposed therebetween, and a second dummy pattern spaced from the second electrode in the first direction with the second opening interposed therebetween.

The first opening and the second opening may have a width measured in the second direction greater than a width of the first electrode and the second electrode measured in the second direction.

The first contact portion and the second contact portion may have widths measured in the first direction and the second direction greater than widths of the first opening and the second opening measured in the first direction and the second direction, respectively.

The first connection electrode may have a shape extending in the first direction, the first contact portion may have a shape protruding from the first opening in the second direction, the second connection electrode may have a shape extending in the first direction, and the second contact portion may have a shape protruding from the second opening in the second direction.

The display device may further include a third electrode spaced from the second electrode in the second direction with the first electrode interposed therebetween, and a first dummy pattern spaced from the first electrode in the first direction with the first opening interposed therebetween, wherein the third electrode extends from the emission area to a separation portion in the sub-region, and the dummy pattern may be located between the separation portion and the first opening.

The light emitting element may include a first light emitting element between the first electrode and the third electrode, and a second light emitting element on the first electrode and the second electrode, the display device may further include a third connection electrode on the third electrode and the first electrode, and in contact with one end of each of the first light emitting element and the second light emitting element.

The display device may further include a third electrode between the first electrode and the second electrode, and a fourth electrode spaced from the third electrode in the second direction with the second electrode interposed therebetween, wherein the light emitting element includes a first light emitting element, a second light emitting element, a third light emitting element, and a fourth light emitting element, the first light emitting element and the third light emitting element are on the first electrode and the third electrode, and the second light emitting element and the fourth light emitting element are on the second electrode and the fourth electrode.

The display device may further include a third connection electrode spaced from the first connection electrode and disposed across the first electrode and the third electrode, a fourth connection electrode spaced from the second connection electrode and disposed across the second electrode and the fourth electrode, and a fifth connection electrode spaced from the third connection electrode and the fourth connection electrode and disposed across the third electrode and the fourth electrode.

The first connection electrode may be in contact with the first light emitting element, the second connection electrode may be in contact with the second light emitting element, the third connection electrode may be in contact with the first light emitting element and the third light emitting element, the fourth connection electrode may be in contact with the second light emitting element and the fourth light emitting element, and the fifth connection electrode may be in contact with the third light emitting element and the fourth light emitting element.

The third connection electrode may include a first extension portion spaced from the first connection electrode in the second direction, a second extension portion spaced from the first connection electrode in the first direction, and a first connection portion connecting the first extension portion to the second extension portion, the fourth connection electrode may include a third extension portion spaced from the second connection electrode in the second direction, a fourth extension portion spaced from the second connection electrode in the first direction, and a second connection portion connecting the third extension portion to the fourth extension portion, and the fifth connection electrode may include a fifth extension portion spaced from the second extension portion in the second direction, a sixth extension portion spaced from the fourth extension portion in the second direction, and a third connection portion connecting the fifth extension portion to the sixth extension portion.

The third connection electrode may be located over the emission area and the sub-region, and is in contact with the third electrode through a first electrode contact hole penetrating the first insulating layer in the sub-region, and the fourth connection electrode may be located over the emission area and the sub-region, and is in contact with the fourth electrode through a second electrode contact hole penetrating the first insulating layer in the sub-region.

The details of other embodiments are included in the detailed description and the accompanying drawings.

### [ADVANTAGEOUS EFFECTS]

The display device according to an embodiment may have an electrode connection structure in which connection electrodes are in direct contact with the third conductive layer, thereby preventing contact failure that may occur due to a material difference between different types of electrodes. In addition, it is possible to prevent the material of the connection electrode from being disconnected due to an undercut that may occur in an electrode separation process.

The effects according to the embodiments are not limited by the contents exemplified above, and more various effects are included in this disclosure.

### [DESCRIPTION OF DRAWINGS]

FIG. 1 is a schematic plan view of a display device according to one or more embodiments;
FIG. 2 is a plan view illustrating one pixel of a display device according to one or more embodiments;
FIG. 3 is an enlarged view of a sub-region in a first sub-pixel of FIG. 2;
FIG. 4 is a cross-sectional view taken along the line N1-N1' of FIG. 2;
FIG. 5 is a cross-sectional view taken along the line N2-N2' of FIG. 3;
FIG. 6 is a cross-sectional view taken along the line N3-N3' of FIG. 3;
FIG. 7 is a schematic view of a light emitting element according to one or more embodiments;
FIGS. 8 to 12 are cross-sectional views illustrating a process of manufacturing a display device according to one or more embodiments;
FIG. 13 is a cross-sectional view illustrating a portion of a display device according to one or more embodiments;
FIG. 14 is a plan view illustrating a sub-pixel of a display device according to one or more embodiments;
FIG. 15 is a cross-sectional view taken along the line N4-N4' of FIG. 14;
FIG. 16 is a cross-sectional view taken along the line N5-N5' of FIG. 14;
FIG. 17 is a plan view illustrating a sub-pixel of a display device according to one or more embodiments;
FIG. 18 is a cross-sectional view taken along the line N6-N6' of FIG. 17;
FIG. 19 is a cross-sectional view taken along the lines N7-N7' and N8-N8' of FIG. 17;
FIG. 20 is a cross-sectional view illustrating a portion of a display device according to one or more embodiments; and
FIGS. 21 and 22 are cross-sectional views illustrating a third conductive layer of a display device according to one or more embodiments.

### [MODES OF THE INVENTION]

The disclosure will now be described more fully hereinafter with reference to the accompanying drawings, in which preferred embodiments of the disclosure are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the disclosure. Similarly, the second element could also be termed the first element.

Hereinafter, embodiments will be described with reference to the accompanying drawings.

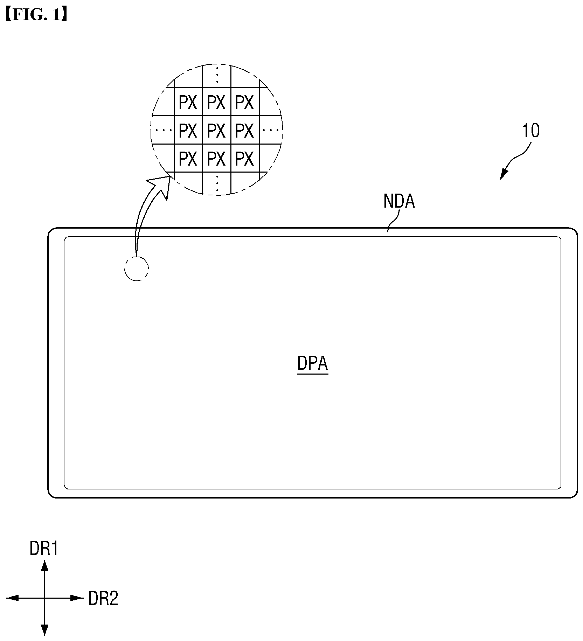

FIG. 1 is a schematic plan view of a display device according to one or more embodiments.

Referring to FIG. 1, a display device 10 displays a moving image or a still image. The display device 10 may refer to any electronic device providing a display screen. Examples of the display device 10 may include a television, a laptop computer, a monitor, a billboard, an Internet-of-Things (IoT) device, a mobile phone, a smartphone, a tablet personal computer (PC), an electronic watch, a smart watch, a watch phone, a head-mounted display, a mobile communication terminal, an electronic notebook, an electronic book, a portable multimedia player (PMP), a navigation device, a game machine, a digital camera, a camcorder, and the like, which provide a display screen.

The display device 10 includes a display panel that provides a display screen. Examples of the display panel may include an inorganic light emitting diode display panel, an organic light emitting display panel, a quantum dot light emitting display panel, a plasma display panel, and a field emission display panel. In the following description, a case where an inorganic light emitting diode display panel is applied as a display panel will be exemplified, but the disclosure is not limited thereto, and other display panels may be applied within the same scope of technical idea.

The shape of the display device 10 may be variously modified. For example, the display device 10 may have a shape such as a rectangular shape elongated in a horizontal direction, a rectangular shape elongated in a vertical direction, a square shape, a quadrilateral shape with rounded corners (e.g., vertices), another polygonal shape, and a circular shape. The shape of a display area DPA of the display device 10 may also be similar to the overall shape of the display device 10. FIG. 1 illustrates the display device 10 having a rectangular shape elongated in a second direction DR2.

The display device 10 may include the display area DPA and a non-display area NDA. The display area DPA is an area where a screen can be displayed, and the non-display area NDA is an area where a screen is not displayed. The display area DPA may also be referred to as an active region, and the non-display area NDA may also be referred to as a non-active region. The display area DPA may substantially occupy the center of the display device 10.

The display area DPA may include a plurality of pixels PX. The plurality of pixels PX may be arranged in a matrix. For example, the plurality of pixels may be arranged along rows and columns of a matrix. The shape of each pixel PX may be a rectangular or square shape in a plan view. However, the disclosure is not limited thereto, and it may be a rhombic shape in which each side is inclined with respect to one direction. Each pixel PX may be arranged in a stripe type or a PENTILE^{®} arrangement structure. In addition, each of the pixels PX may include one or more light emitting elements that emit light of a specific wavelength band to display a specific color.

The non-display area NDA may be disposed around the display area DPA. The non-display area NDA may completely or partially surround the display area DPA along the edge or periphery of the display area DPA. The display area DPA may have a rectangular shape, and the non-display area NDA may be disposed adjacent to four sides of the display area DPA. The non-display area NDA may form a bezel of the display device 10. Wires or circuit drivers included in the display device 10 may be disposed in the non-display area NDA, or external devices may be mounted thereon.

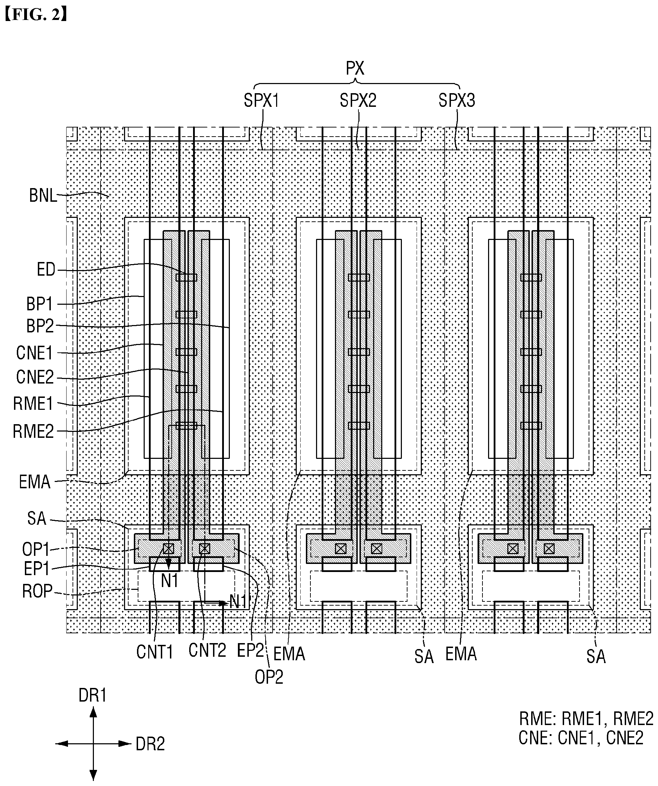

FIG. 2 is a plan view illustrating one pixel of a display device according to one or more embodiments.

Referring to FIG. 2, each of the pixels PX of the display device 10 may include a plurality of sub-pixels SPXn (n ranging from 1 to 3). For example, one pixel PX may include a first sub-pixel SPX1, a second sub-pixel SPX2, and a third sub-pixel SPX3. The first sub-pixel SPX1 may emit light of a first color, the second sub-pixel SPX2 may emit light of a second color, and the third sub-pixel SPX3 may emit light of a third color. For example, the first color may be blue, the second color may be green, and the third color may be red. However, the disclosure is not limited thereto, and the sub-pixels SPXn may emit light of the same color. In one or more embodiments, each of the sub-pixels SPXn may emit blue light. In addition, although it is illustrated in the drawing that one pixel PX includes three sub-pixels SPXn, the disclosure is not limited thereto, and the pixel PX may include a larger number of sub-pixels SPXn.

Each sub-pixel SPXn of the display device 10 may include an emission area EMA and a non-emission area. The emission area EMA may be an area in which the light emitting element ED is disposed to emit light of a specific wavelength band. The non-emission area may be a region in which the light emitting element ED is not disposed and a region from which light is not emitted because light emitted from the light emitting element ED does not reach it.

The emission area may include an area in which the light emitting element ED is disposed, and an area adjacent to the light emitting element ED to emit light emitted from the light emitting element ED. Without being limited thereto, the emission area EMA may also include an area in which light emitted from the light emitting element ED is reflected or refracted by another member and emitted. The plurality of light emitting elements ED may be disposed in each sub-pixel SPXn, and the emission area may be formed to include an area where the light emitting elements ED are disposed and an area adjacent thereto.

Although it is shown in the drawing that the sub-pixels SPXn have the emission areas EMA that are substantially identical in size, the disclosure is not limited thereto. In one or more embodiments, the emission areas EMA of the sub-pixels SPXn may have different sizes according to a color or wavelength band of light emitted from the light emitting element ED disposed in each sub-pixel.

In addition, each sub-pixel SPXn may further include a sub-region SA disposed in the non-emission area. The sub-region SA may be disposed at one side of the emission area EMA in the first direction DR1, and may be disposed between the emission areas EMA of the sub-pixels SPXn adjacent in the first direction DR1. For example, the emission areas EMA and the sub-regions SA may be repeatedly arranged along the second direction DR2, respectively, while being alternately arranged along the first direction DR1. However, the disclosure is not limited thereto, and the arrangement of the emission areas EMA and the sub-regions SA in the plurality of pixels PX may be different from that shown in FIG. 2.

A bank layer BNL may be disposed between the sub-regions SA and between the emission areas EMA, and the distance therebetween may vary with the width of the bank layer BNL. Light may not be emitted from the sub-region SA because the light emitting element ED is not disposed in the sub-region SA, but an electrode RME disposed in each sub-pixel SPXn may be partially disposed in the sub-region SA. The electrodes RME disposed in different sub-pixels SPXn may be disposed to be separated at a separation portion ROP of the sub-region SA.

The bank layer BNL may include portions extending in the first direction DR1 and the second direction DR2 in a plan view to be arranged in a grid pattern over the entire surface of the display area DPA. The bank layer BNL may be disposed along the boundaries between the sub-pixels SPXn to delimit the neighboring sub-pixels SPXn. Further, the bank layer BNL may be disposed so as to surround the emission area EMA disposed for each sub-pixel SPXn to distinguish the emission areas EMA.

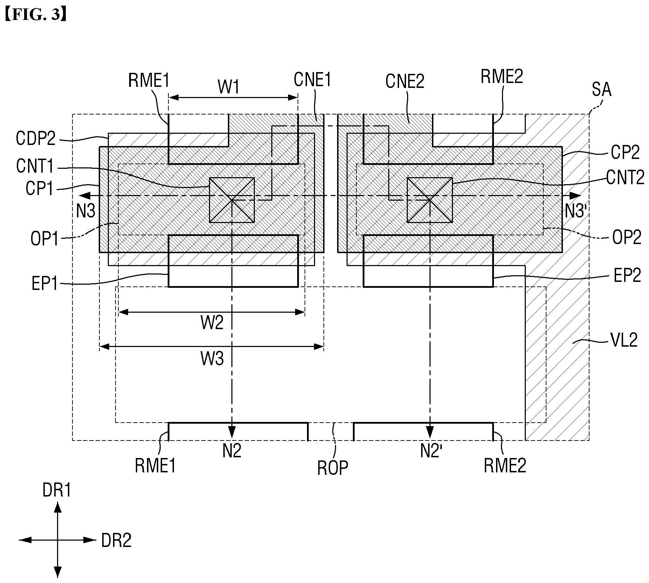

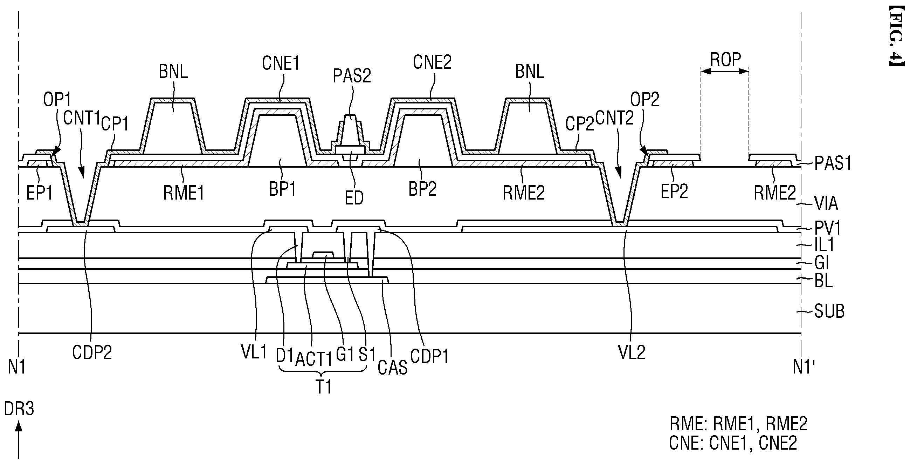

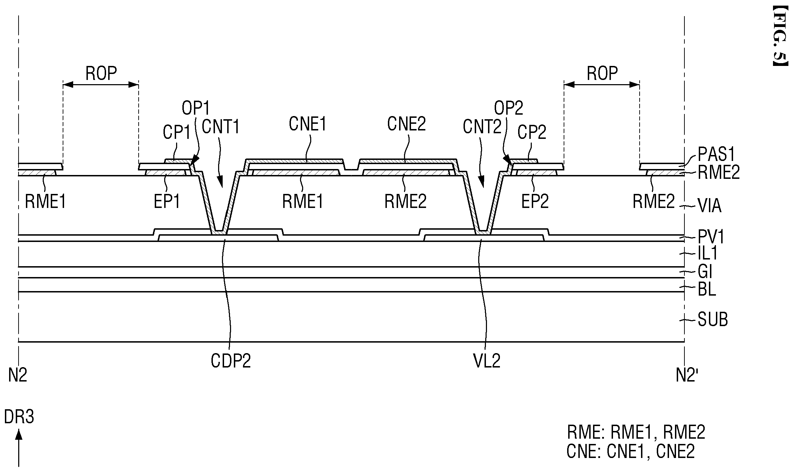

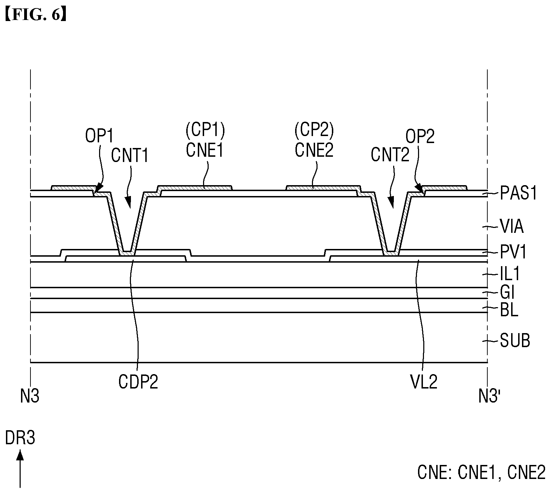

FIG. 3 is an enlarged view of a sub-region in a first sub-pixel of FIG. 2. FIG. 4 is a cross-sectional view taken along the line N1-N1' of FIG. 2. FIG. 5 is a cross-sectional view taken along the line N2-N2' of FIG. 3. FIG. 6 is a cross-sectional view taken along the line N3-N3' of FIG. 3. FIG. 3 illustrates the arrangement of contact holes CNT1 and CNT2 disposed in the sub-region SA of one sub-pixel SPXn and a portion of a third conductive layer disposed therebelow. FIG. 4 illustrates a cross section traversing both ends of the light emitting element ED and the plurality of contact holes CNT1 and CNT2 disposed in the first sub-pixel SPX1 in one pixel PX shown in FIG. 2. FIGS. 5 and 6 illustrate cross sections traversing the contact holes CNT1 and CNT2 disposed in the sub-region SA of the first sub-pixel SPX1 in the first direction DR1 and the second direction DR2, respectively.

Referring to FIGS. 3 to 6 in conjunction with FIG. 2, the display device 10 may include a first substrate SUB and a semiconductor layer, a plurality of conductive layers, and a plurality of insulating layers disposed on the first substrate SUB. The semiconductor layer, the conductive layers, and the insulating layers may each constitute a circuit layer and a display element layer of the display device 10.

For example, the first substrate SUB may be an insulating substrate. The first substrate SUB may be made of an insulating material such as glass, quartz, or polymer resin. Further, the first substrate SUB may be a rigid substrate, but may also be a flexible substrate which can be bent, folded and/or rolled.

A first conductive layer may be disposed on the first substrate SUB. The first conductive layer includes a lower metal layer CAS that is disposed to overlap an active layer ACT1 of a first transistor T1 in the thickness direction of the first substrate SUB (i.e., a third direction DR3). The lower metal layer CAS may include a light blocking material to prevent light from reaching the active layer ACT1 of the first transistor. However, the lower metal layer CAS may be omitted.

The buffer layer BL may be disposed on the lower metal layer CAS and the first substrate SUB. The buffer layer BL may be formed on the first substrate SUB to protect the transistors of the pixel PX from moisture permeating through the first substrate SUB susceptible to moisture permeation, and may perform a surface planarization function.

The semiconductor layer is disposed on the buffer layer BL. The semiconductor layer may include the active layer ACT1 of the first transistor T1. The active layer ACT1 may be arranged to partially overlap in the thickness direction of the first substrate SUB (i.e., a third direction DR3) the gate electrode G1 of the second conductive layer to be described later.

The semiconductor layer may include polycrystalline silicon, monocrystalline silicon, oxide semiconductor, and the like. In one or more embodiments, the semiconductor layer may include polycrystalline silicon. The oxide semiconductor may be an oxide semiconductor containing indium (In). For example, the oxide semiconductor may be at least one of indium tin oxide (ITO), indium zinc oxide (IZO), indium gallium oxide (IGO), indium zinc tin oxide (IZTO), indium gallium tin oxide (IGTO), indium gallium zinc oxide (IGZO), or indium gallium zinc tin oxide (IGZTO).

Although it is illustrated in the drawing that one first transistor T1 is disposed in the sub-pixel SPXn of the display device 10, the disclosure is not limited thereto, and the display device 10 may include a larger number of transistors.

The first gate insulating layer GI is disposed on the semiconductor layer and the buffer layer BL. The first gate insulating layer GI may serve as a gate insulating film of the first transistor T1.

The second conductive layer is disposed on the first gate insulating layer GI. The second conductive layer may include the gate electrode G1 of the first transistor T1. The gate electrode G1 may be arranged to overlap the channel region of the active layer ACT1 in the third direction DR3 which is the thickness direction of the first substrate SUB.

A first interlayer insulating layer IL1 is disposed on the second conductive layer. The first interlayer insulating layer IL1 may function as an insulating film between the second conductive layer and other layers disposed thereon, and may protect the second conductive layer.

A third conductive layer is disposed on the first interlayer insulating layer IL1. The third conductive layer may include a first voltage line VL1, a second voltage line VL2, and a plurality of conductive patterns CDP1 and CDP2 that are arranged in the display area DPA.

The first voltage line VL1 may be applied with a high potential voltage (or a first power voltage) transmitted to the light emitting element ED, and the second voltage line VL2 may be applied with a low potential voltage (or a second power voltage) transmitted to the light emitting element ED. The first voltage line VL1 may apply the first power voltage to the light emitting element ED through the first transistor T1 and a first connection electrode CNE1 to be described later, and the second voltage line VL2 may apply the second power voltage to the light emitting element ED through a second connection electrode CNE2. A portion of the first voltage line VL1 may be in contact with the active layer ACT1 of the first transistor T1 through a contact hole penetrating the first interlayer insulating layer IL1 and the first gate insulating layer GI. The first voltage line VL1 may serve as a first drain electrode D1 of the first transistor T1.

A first conductive pattern CDP1 may be in contact with the active layer ACT1 of the first transistor T1 through a contact hole penetrating the first interlayer insulating layer IL1 and the first gate insulating layer GI. Further, the first conductive pattern CDP1 may be in contact with the lower metal layer CAS through another contact hole penetrating the first interlayer insulating layer IL1, the first gate insulating layer GI, and the buffer layer BL. The first conductive pattern CDP1 may serve as a first source electrode S1 of the first transistor T1.

The second conductive pattern CDP2 may be connected to the first connection electrode CNE1 to be described later. Further, the second conductive pattern CDP2 may be electrically connected to the first transistor T1 through the first conductive pattern CDP1. Although it is illustrated in the drawing that the first conductive pattern CDP1 and the second conductive pattern CDP2 are separated from each other, the second conductive pattern CDP2 and the first conductive pattern CDP1 may be integrated to form one pattern in one or more embodiments.

On the other hand, although it is illustrated in the drawing that the first conductive pattern CDP1 and the second conductive pattern CDP2 are formed in the same layer, the disclosure is not limited thereto. In one or more embodiments, the second conductive pattern CDP2 may be formed as a fourth conductive layer disposed on the third conductive layer with several insulating layers interposed between the first conductive pattern CDP1 and another conductive layer, e.g., the third conductive layer. In this case, the first and second voltage lines VL1 and VL2 may also be formed as the fourth conductive layer instead of the third conductive layer, and the first voltage line VL1 may be electrically connected to the drain electrode D1 of the first transistor T1 through another conductive pattern.

A first passivation layer PV1 is disposed on the third conductive layer. The first passivation layer PV1 may function as an insulating layer between the third conductive layer and other layers and may protect the third conductive layer.

The buffer layer BL, the first gate insulating layer GI, the first interlayer insulating layer IL1, and the first passivation layer PV1 described above may be formed of a plurality of inorganic layers stacked in an alternating manner. For example, the buffer layer BL, the first gate insulating layer GI, the first interlayer insulating layer IL1, and the first passivation layer PV1 may be formed as a double layer formed by stacking, or a multilayer formed by alternately stacking, inorganic layers including at least one of silicon oxide (SiOₓ), silicon nitride (SiNₓ), or silicon oxynitride (SiOₓN_{y}). However, the disclosure is not limited thereto, and the buffer layer BL, the first gate insulating layer GI, the first interlayer insulating layer IL1, and the first passivation layer PV1 may be formed as a single inorganic layer containing the above-described insulating material. Further, in one or more embodiments, the first interlayer insulating layer IL1 may be made of an organic insulating material such as polyimide (PI) or the like.

The second conductive layer and the third conductive layer may be formed as a single layer or multiple layers made of any one of molybdenum (Mo), aluminium (Al), chromium (Cr), gold (Au), titanium (Ti), nickel (Ni), neodymium (Nd) and copper (Cu) or an alloy thereof. However, it is not limited thereto.

A via layer VIA is disposed on the third conductive layer in the display area DPA. The via layer VIA may include an organic insulating material, for example, an organic insulating material such as polyimide (PI), to perform a surface planarization function.

A plurality of bank patterns BP1 and BP2, a plurality of electrodes RME (RME1 and RME2), the bank layer BNL, the plurality of light emitting elements ED, and a plurality of connection electrodes CNE (CNE1 and CNE2) are disposed as a display element layer on the via layer VIA. Further, a plurality of insulating layers PAS1 and PAS2 may be disposed on the via layer VIA.

The plurality of bank patterns BP1 and BP2 may be directly disposed on the via layer VIA in the display area DPA. The bank patterns BP1 and BP2 may have a shape extending in the first direction DR1 and may be spaced from each other in the second direction DR2. For example, the bank patterns BP1 and BP2 may include a first bank pattern BP1 and a second bank pattern BP2 spaced from each other in the emission area EMA of each sub-pixel SPXn. The first bank pattern BP1 may be located on the left side that is one side in the second direction DR2 with respect to the central portion of the emission area EMA, and the second bank pattern BP2 may be located on the right side that is the other side in the second direction DR2 with respect to the central portion of the emission area EMA. The plurality of light emitting elements ED may be arranged between the first bank pattern BP1 and the second bank pattern BP2.

The extension lengths of the bank patterns BP1 and BP2 in the first direction DR1 may be smaller than the length of the emission area EMA surrounded by the bank layer BNL in the first direction DR1. The bank patterns BP1 and BP2 may be arranged in the emission area EMA of the sub-pixel SPXn in the entire display area DPA to form an island-shaped pattern having a small width and extending in one direction. Although it is illustrated in the drawing that two bank patterns BP1 and BP2 having the same width are arranged for each sub-pixel SPXn, the disclosure is not limited thereto. The number and the shape of the bank patterns BP1 and BP2 may vary depending on the number or the arrangement structure of the electrodes RME.

At least a portion of each of the bank patterns BP1 and BP2 may protrude with respect to the top surface of the via layer VIA. The protruding portions of the bank patterns BP1 and BP2 may have inclined surfaces, and the light emitted from the light emitting element ED may be reflected by the electrode RME disposed on the bank patterns BP1 and BP2 and emitted in the upward direction of the via layer VIA. However, the disclosure is not limited thereto, and the bank patterns BP1 and BP2 may have curved semicircular or semi-elliptical outer surfaces. The bank patterns BP1 and BP2 may include an organic insulating material such as polyimide (PI), but the disclosure is not limited thereto.

In one or more embodiments, the top surfaces of the bank patterns BP1 and BP2 may be lower than the top surface of the bank layer BNL, and the thicknesses of the bank patterns BP1 and BP2 may be smaller than or equal to the thickness of the bank layer BNL. Unlike the bank layer BNL that prevents ink from overflowing to adjacent sub-pixels SPXn, the bank patterns BP1 and BP2 are arranged to partition the space where the light emitting elements ED are arranged or to form the inclined surfaces where the electrodes RME are arranged, so that the thicknesses or the heights of the bank patterns BP1 and BP2 may be different from that of the bank layer BNL.

The plurality of electrodes RME have a shape extending in one direction and are disposed for each sub-pixel SPXn. The plurality of electrodes RME may extend in the first direction DR1 to be disposed across the emission area EMA of the sub-pixel SPXn, and may be disposed to be spaced from each other in the second direction DR2.

The display device 10 includes the first electrode RME1 and the second electrode RME2 arranged in each sub-pixel SPXn. The first electrode RME1 is located on the left side with respect to a center of the emission area EMA, and the second electrode RME2 is located on the right side with respect to the center of the emission area EMA while being spaced from the first electrode RME1 in the second direction DR2. A first electrode RME1 may be disposed on the first bank pattern BP1, and a second electrode RME2 may be disposed on the second bank pattern BP2. The first electrode RME1 and the second electrode RME2 may be partially arranged in the corresponding sub-pixel SPXn and the sub-region SA over the bank layer BNL. According to one or more embodiments, dummy patterns EP1 and EP2 separated from the electrodes RME may be disposed in the sub-region SA, and the electrodes RME of the corresponding sub-pixel SPXn may be spaced from the dummy patterns EP1 and EP2. In addition, the electrodes RME of the sub-pixel SPXn adjacent in the first direction DR1 may be spaced from the dummy patterns EP1 and EP2 with respect to the separation portion ROP. In the manufacturing process of the display device 10, the electrodes RME may be disposed to extend in one direction, and may be partially separated after the process of arranging the light emitting elements ED. In the above separation process, the electrodes extending in one direction may be separated into individual electrodes RME disposed for each sub-pixel SPXn, and at the same time may be separated in the sub-region SA to form the dummy patterns EP1 and EP2. The contact holes CNT1 and CNT2 penetrating the via layer VIA may be disposed in a space where the electrodes RME and the dummy patterns EP1 and EP2 are spaced from each other, and the connection electrodes CNE may be connected directly to the third conductive layer through the contact holes CNT1 and CNT2.

The first insulating layer PAS1 may be disposed on the via layer VIA and the plurality of electrodes RME. In one or more embodiments, the first insulating layer PAS1 may be disposed on the dummy patterns EP1 and EP2. The first insulating layer PAS1 may protect the plurality of electrodes RME and insulate different electrodes RME from each other. For example, the first insulating layer PAS1 is disposed to cover the electrodes RME before the bank layer BNL is formed, so that it is possible to prevent the electrodes RME from being damaged in a process of forming the bank layer BNL. In addition, the first insulating layer PAS1 may prevent the light emitting element ED disposed thereon from being damaged by direct contact with other members.

In one or more embodiments, the first insulating layer PAS1 may have stepped portions such that the top surface thereof is partially depressed between the electrodes RME that are spaced in the second direction DR2. The light emitting element ED may be disposed on the top surface of the first insulating layer PAS1, where the stepped portions are formed, and thus a space may remain between the light emitting element ED and the first insulating layer PAS1.

According to one or more embodiments, the first insulating layer PAS1 may include a plurality of openings OP1 and OP2 exposing a portion of the top surface of a layer disposed therebelow, e.g., the via layer VIA, and the separation portion ROP. For example, the first insulating layer PAS1 may include the openings OP1 and OP2 exposing a portion of the via layer VIA where the contact holes CNT1 and CNT2 are disposed in the sub-region SA, and the separation portion ROP exposing a portion of the sub-region SA where the electrodes RME of the adjacent sub-pixel SPXn and the dummy patterns EP1 and EP2 are spaced from each other. Each of the openings OP1 and OP2 and the separation portion ROP may be formed to perform a process for separating the electrodes RME in the manufacturing process of the display device 10, and the connection electrodes CNE may be connected to the third conductive layer through the contact holes CNT1 and CNT2 exposed by the openings OP1 and OP2.

The bank layer BNL may be disposed on the first insulating layer PAS1. The bank layer BNL may include portions extending in the first direction DR1 and the second direction DR2, and may surround the sub-pixels SPXn. Further, the bank layer BNL may surround and distinguish the emission area EMA and the sub-region SA of each sub-pixel SPXn, and may surround the outermost portion of the display area DPA and distinguish the display area DPA and the non-display area NDA. The bank layer BNL is disposed in the entire display area DPA to form a grid pattern, and the regions exposed by the bank layer BNL in the display area DPA may be the emission area EMA and the sub-region SA.

Similarly to the bank patterns BP1 and BP2, the bank layer BNL may have a certain height. In one or more embodiments, the top surface of the bank layer BNL may be higher than that of the bank patterns BP1 and BP2, and the thickness of the bank layer BNL may be equal to or greater than that of the bank patterns BP1 and BP2. The bank layer BNL may prevent ink from overflowing to adjacent sub-pixels SPXn in an inkjet printing process during the manufacturing process of the display device 10. Similarly to the bank patterns BP1 and BP2, the bank layer BNL may include an organic insulating material such as polyimide.

The plurality of light emitting elements ED may be arranged on the first insulating layer PAS1. The light emitting element ED may have a shape extending in one direction, and may be disposed such that one direction in which the light emitting element ED extends is parallel to the first substrate SUB. As will be described later, the light emitting element ED may include a plurality of semiconductor layers arranged along one direction in which the light emitting element ED extends, and the plurality of semiconductor layers may be sequentially arranged along the direction parallel to the top surface of the first substrate SUB. However, the disclosure is not limited thereto, and the plurality of semiconductor layers may be arranged along the direction perpendicular to the first substrate SUB when the light emitting element ED has another structure.

The plurality of light emitting elements ED may be disposed above the electrodes RME that are spaced from each other in the second direction DR2 between the bank patterns BP1 and BP2. The extension length of the light emitting element ED may be greater than the gap between the electrodes RME that are spaced from each other in the second direction DR2. The light emitting elements ED may have at least one end disposed on any one of the electrodes RME that are different from each other, or may have both ends disposed on the electrodes RME that are different from each other, respectively. An extension direction of each electrode RME may be substantially perpendicular to an extension direction of the light emitting element ED. The light emitting elements ED may be disposed to be spaced from each other along the first direction DR1 in which the electrodes RME extend, and may be aligned substantially parallel to each other. However, the disclosure is not limited thereto, and the light emitting elements ED may each be arranged to extend in a direction oblique to the extension direction of the electrodes RME.

The light emitting elements ED disposed in each sub-pixel SPXn may emit light of different wavelength bands depending on a material constituting the semiconductor layer. However, the disclosure is not limited thereto, and the light emitting elements ED arranged in each sub-pixel SPXn may include the semiconductor layer of the same material and emit light of the same color. The light emitting elements ED may be electrically connected to the electrode RME and the conductive layers below the via layer VIA while being in contact with the connection electrodes CNE (CNE1 and CNE2), and may emit light of a specific wavelength band by receiving an electrical signal.

The second insulating layer PAS2 may be disposed on the plurality of light emitting elements ED. The second insulating layer PAS2 may be disposed to extend in the first direction DR1 between the bank patterns BP1 and BP2 and may be disposed to partially surround the outer surfaces of the plurality of light emitting elements ED. The second insulating layer PAS2 may be disposed not to cover both sides or both ends of the light emitting element ED, and the both sides or both ends of the light emitting element ED may be in contact with the connection electrodes CNE. The second insulating layer PAS2 may protect the light emitting elements ED while fixing the light emitting elements ED during the manufacturing process of the display device 10. Further, a portion of the second insulating layer PAS2 may be disposed to fill the space between the light emitting element ED and the first insulating layer PAS1 thereunder.

The plurality of connection electrodes CNE (CNE1 and CNE2) may be disposed on the plurality of electrodes RME and the light emitting elements ED, and may be in contact with the light emitting element ED and the third conductive layer. The connection electrode CNE may be in contact with one end of the light emitting element ED, and the third conductive layer through the contact hole CNT1 and CNT2 penetrating the via layer VIA.

The first connection electrode CNE1 may have a shape extending in the first direction DR1 and may be disposed on the first electrode RME1. The first connection electrode CNE1 may partially overlap the first electrode RME1 and may be disposed across the emission area EMA and the sub-region SA over the bank layer BNL. The second connection electrode CNE2 may have a shape extending in the first direction DR1 and may be disposed on the second electrode RME2. The second connection electrode CNE2 may partially overlap the second electrode RME2 and may be disposed across the emission area EMA and the sub-region SA over the bank layer BNL.

According to one or more embodiments, in the display device 10, the connection electrodes CNE may be in direct contact with the third conductive layer through the contact holes CNT1 and CNT2 disposed in the sub-region SA. The first connection electrode CNE1 may be in direct contact with the second conductive pattern CDP2 through the first contact hole CNT1 penetrating the first passivation layer PV1 and the via layer VIA, and the second connection electrode CNE2 may be in direct contact with the second voltage line VL2 through the second contact hole CNT2 penetrating the first passivation layer PV1 and the via layer VIA. The first connection electrode CNE1 may be electrically connected to the first transistor T1 through the second electrode pattern CDP2 and the first electrode pattern CDP1 and applied with the first power voltage. The second connection electrode CNE2 may be electrically connected to the second voltage line VL2 and applied with the second power voltage. Each connection electrode CNE may be in contact with the light emitting element ED in the emission area EMA to transmit a power voltage to the light emitting element ED.

The connection electrodes CNE may include a conductive material. For example, they may include ITO, IZO, ITZO, aluminium (Al), or the like. As an example, the connection electrode CNE may include a transparent conductive material, and light emitted from the light emitting element ED may pass through the connection electrode CNE and proceed toward the electrodes RME disposed in the bank patterns BP1 and BP2. However, it is not limited thereto.

Each of the first insulating layer PAS1 and the second insulating layer PAS2 described above may include an inorganic insulating material or an organic insulating material. As one example, the first insulating layer PAS1 may include an inorganic insulating material, and the second insulating layer PAS2 may include an organic insulating material. However, the disclosure is not limited thereto. In addition, each or at least one of the first insulating layer PAS1 and the second insulating layer PAS2 may be formed in a structure in which a plurality of insulating layers are alternately or repeatedly stacked.

In one or more embodiments, the electrodes RME may be connected to the third conductive layer through the contact holes CNT1 and CNT2 during the manufacturing process of the display device 10, and then a portion of the electrodes RME disposed in the contact holes CNT1 and CNT2 may be separated in a subsequent process. During the manufacturing process of the display device 10, each of the first electrode RME1 and the second electrode RME2 may be disposed across the plurality of sub-pixels SPXn by extending in the first direction DR1 as one electrode, and then may be partially separated to be disposed for each sub-pixel SPXn. Before forming the connection electrodes CNE, a portion of the electrodes RME disposed in the sub-region SA may be separated. For example, the portion of the electrodes RME disposed in the contact holes CNT1 and CNT2 may be removed to expose the contact holes CNT1 and CNT2, and the connection electrode CNE connected to the light emitting element ED may be in direct contact with the third conductive layer through the contact holes CNT1 and CNT2. Because the connection electrodes CNE are brought into direct contact with the third conductive layer without being in contact with the electrode RME, a problem of poor contact between the electrodes may be reduced.

The first insulating layer PAS1 may include the plurality of openings OP1 and OP2 for exposing a layer disposed therebelow and the separation portion ROP so that a process of separating a portion of the electrodes RME is performed in the manufacturing process of the display device 10. The electrodes RME disposed across the plurality of sub-pixels SPXn may be partially removed in the openings OP1 and OP2 and the separation portion ROP of the first insulating layer PAS1 to be disposed separately for each of the sub-pixels SPXn.

The openings OP1 and OP2 may include a first opening OP1 disposed to overlap the first contact hole CNT1 and a second opening OP2 disposed to overlap the second contact hole CNT2. The first electrode RME1 and the second electrode RME2 may be disposed on the upper side, which is one side in the first direction DR1, of the first opening OP1 and the second opening OP2, respectively, and a portion separated from the first electrode RME1 and the second electrode RME2 may be disposed on the lower side, which is the other side in the first direction DR1, of the first opening OP1 and the second opening OP2.

According to one or more embodiments, the display device 10 may include the plurality of dummy patterns EP1 and EP2 that are disposed in the sub-region SA and spaced from the electrodes RME with the openings OP1 and OP2 interposed therebetween. The first dummy pattern EP1 may be spaced from the first electrode RME1 in the first direction DR1 with the first opening OP1 interposed therebetween, and the second dummy pattern EP2 may be spaced from the second electrode RME2 in the first direction DR1 with the second opening OP2 interposed therebetween. In addition, the electrodes RME disposed in different sub-pixels SPXn may be spaced from each other at the separation portion ROP, and the separation portion ROP and the dummy patterns EP1 and EP2 may be disposed between the electrodes RME of the different sub-pixels SPXn. The dummy patterns EP1 and EP2 may be spaced from electrodes RME of another sub-pixel SPXn in the first direction DR1 with the separation portion ROP interposed therebetween.

Because each of the dummy patterns EP1 and EP2 is formed by being separated from the electrode RME, the structure and material thereof may be similar to those of the electrode RME. The dummy patterns EP1 and EP2 may be aligned with the electrodes RME in the first direction DR1, respectively, and the width thereof measured in the second direction DR2 may be the same as that of the electrode RME. However, the disclosure is not limited thereto, and the structure of the dummy patterns EP1 and EP2 may vary depending on the shapes of the electrodes RME.

The connection electrodes CNE may include contact portions CP1 and CP2 disposed on the openings OP1 and OP2, respectively, which are portions where the electrodes RME and the dummy patterns EP1 and EP2 are spaced from each other. Each of the contact portions CP1 and CP2 may have a shape that can completely cover the openings OP1 and OP2 and the contact holes CNT1 and CNT2, so that even if it is disposed on a portion from which the electrode RME is removed, it may be in contact with the third conductive layer without disconnection of the material.

According to one or more embodiments, the process of separating the electrodes RME in the openings OP1 and OP2 and the separation portion ROP of the first insulating layer PAS1 may be performed by a wet etching process. Undercuts may be formed in the electrodes RME disposed under the first insulating layer PAS1 at the boundary between and the separation portion ROP and the openings OP1 and OP2 of the first insulating layer PAS1. The sides of the electrodes RME1 and RME2 disposed in the sub-region SA and facing (or opposing) the dummy patterns EP1 and EP2 may be spaced from the sides of the openings OP1 and OP2 more inward than the first insulating layer PAS1. For example, one sides of the first electrode RME1 and the second electrode RME2 disposed in the sub-region SA, i.e. the lower sides thereof facing the dummy patterns EP1 and EP2 may be disposed to be spaced from one sides in the first direction DR1 of the openings OP1 and OP2 more inward than the first insulating layer PAS1. Similarly, one sides of the dummy patterns EP1 and EP2, i.e., the upper sides thereof facing the electrode RME may be disposed to be spaced from the other sides in the first direction DR1 of the openings OP1 and OP2 more inward than the first insulating layer PAS1. In addition, at both sides of the separation portion ROP in the first direction DR1, undercuts may be formed on one sides of the dummy patterns EP1 and EP2 and the electrodes RME.

The undercuts formed by separating the electrodes RME after forming the first insulating layer PAS1 may cause disconnection of the material of the connection electrode CNE disposed thereon. To prevent this, the openings OP1 and OP2 of the first insulating layer PAS1 and the contact portions CP1 and CP2 of the connection electrodes CNE may have a width greater than that of the electrodes RME. According to one or more embodiments, a first width W1 of the electrodes RME measured in the second direction DR2 may be smaller than widths W2 and W3 of the openings OP1 and OP2 and the contact portions CP1 and CP2 of the connection electrodes CNE measured in the second direction DR2. The openings OP1 and OP2 may be formed to have a second width W2 greater than the first width W1 of the electrodes RME, and the electrodes RME may not be disposed below both sides in the second direction DR2 of the openings OP1 and OP2 in the first insulating layer PAS1. In the manufacturing process of the display device 10, as the openings OP1 and OP2 are formed to completely expose both sides of the electrodes RME in the second direction DR2, the electrodes RME may be completely separated in the openings OP1 and OP2 to be spaced from the dummy patterns EP1 and EP2. Accordingly, even if undercuts are formed in the electrodes RME and the dummy patterns EP1 and EP2 disposed below both sides in the first direction DR1 of the openings OP1 and OP2 in the first insulating layer PAS1, because the via layer VIA, and not the electrodes RME, is disposed below both sides in the second direction DR2 of the openings OP1 and OP2, the material of the contact portions CP1 and CP2 of the connection electrodes CNE disposed in the openings OP1 and OP2 may be prevented from being disconnected due to the undercuts.

Because the electrodes RME extend in the first direction DR1 and undercuts are formed at the side in the first direction DR1 of the openings OP1 and OP2, the contact portions CP1 and CP2 of the connection electrodes CNE may have a shape that can cover the sides in the second direction DR2 of the openings OP1 and OP2, which are portions where undercuts are not formed. In one or more embodiments, the connection electrodes CNE may have a shape substantially extending in the first direction DR1, but the contact portions CP1 and CP2 disposed on the openings OP1 and OP2 may have a shape protruding in the second direction DR2, and a third width W3 of the contact portions CP1 and CP2 may be greater than the second width W2 of the openings OP1 and OP2. A first contact portion CP1 of the first connection electrode CNE1 may be formed to have a width greater than that of the first opening OP1 in the first direction DR1 and the second direction DR2, and a second contact portion CP2 of the second connection electrode CNE2 may be formed to have a width greater than that of the second opening OP2 in the first direction DR1 and the second direction DR2.

On both sides in the first direction DR1 of each of the openings OP1 and OP2, the contact portions CP1 and CP2 of the connection electrodes CNE may be disposed on the undercuts formed below the first insulating layer PAS1 while overlapping the electrodes RME or the dummy patterns EP1 and EP2 in the thickness direction of the first substrate SUB (i.e., the third direction DR3). On the other hand, on both sides in the second direction DR2 of each of the openings OP1 and OP2, the contact portions CP1 and CP2 of the connection electrodes CNE may be disposed to cover the inner sides of the openings OP1 and OP2 of the first insulating layer PAS1, without overlapping the electrodes RME in the thickness direction of the first substrate SUB (i.e., the third direction DR3). In addition, because the openings OP1 and OP2 are formed to have a diameter greater than that of the contact holes CNT1 and CNT2, respectively, the contact portions CP1 and CP2 of the connection electrodes CNE may be disposed directly on the via layer VIA around the contact holes CNT1 and CNT2.

The display device 10 according to one or more embodiments may have an electrode connection structure in which the connection electrodes CNE are in direct contact with the third conductive layer without passing through the electrode RME, and thus it is possible to prevent contact failure that may be caused by material difference between the electrode RME and the connection electrode CNE. In addition, even if the connection electrode CNE is formed after the process of separating the electrodes RME, the openings OP1 and OP2 of the first insulating layer PAS1 are formed to have a width greater than that of the electrode RME, and thus it is also possible to prevent the material of the connection electrode CNE from being disconnected due to an undercut that may occur in the process of separating the electrodes RME.

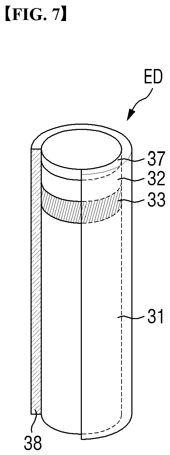

FIG. 7 is a schematic view of a light emitting element according to one or more embodiments.

Referring to FIG. 7, the light emitting element ED may be a light emitting diode. For example, the light emitting element ED may be an inorganic light emitting diode that has a nanometer or micrometer size, and is made of an inorganic material. The light emitting element ED may be aligned between two electrodes having polarity when an electric field is formed in a specific direction between two electrodes facing (or opposing) each other.

The light emitting element ED according to one or more embodiments may have a shape elongated in one direction. The light emitting element ED may have a shape of a cylinder, a rod, a wire, a tube, or the like. However, the shape of the light emitting element ED is not limited thereto, and the light emitting element ED may have a polygonal prism shape such as a regular cube, a rectangular parallelepiped and a hexagonal prism, or may have various shapes such as a shape elongated in one direction and having an outer surface partially inclined.

The light emitting element ED may include a semiconductor layer doped with any conductivity type (e.g., p-type or n-type) impurities. The semiconductor layer may emit light of a specific wavelength band by receiving an electrical signal applied from an external power source. The light emitting element ED may include a first semiconductor layer 31, a second semiconductor layer 32, a light emitting layer 33, an electrode layer 37, and an insulating film 38.

The first semiconductor layer 31 may be an n-type semiconductor. The first semiconductor layer 31 may include a semiconductor material having a chemical formula of AlₓGa_{y}In_{1-x-y}N (0≤x≤1, 0≤y≤1, 0≤x+y≤1). For example, the first semiconductor layer 31 may be any one or more of n-type doped AlGaInN, GaN, AlGaN, InGaN, AIN and InN. The n-type dopant doped into the first semiconductor layer 31 may be Si, Ge, Sn, or the like.

The second semiconductor layer 32 is disposed on the first semiconductor layer 31 with the light emitting layer 33 therebetween. The second semiconductor layer 32 may be a p-type semiconductor, and the second semiconductor layer 32 may include a semiconductor material having a chemical formula of AlₓGa_{y}In_{1-x-y}N (0≤x≤1, 0≤y≤1, 0≤x+y≤1). For example, the second semiconductor layer 32 may be any one or more of p-type doped AlGaInN, GaN, AlGaN, InGaN, AIN and InN. The p-type dopant doped into the second semiconductor layer 32 may be Mg, Zn, Ca, Se, Ba, or the like.

Although it is illustrated in the drawing that the first semiconductor layer 31 and the second semiconductor layer 32 are configured as one layer, the disclosure is not limited thereto. Depending on the material of the light emitting layer 33, the first semiconductor layer 31 and the second semiconductor layer 32 may further include a larger number of layers, such as a cladding layer or a tensile strain barrier reducing (TSBR) layer.

The light emitting layer 33 is disposed between the first semiconductor layer 31 and the second semiconductor layer 32. The light emitting layer 33 may include a material having a single or multiple quantum well structure. When the light emitting layer 33 includes a material having a multiple quantum well structure, a plurality of quantum layers and well layers may be stacked alternately. The light emitting layer 33 may emit light by coupling of electron-hole pairs according to an electrical signal applied through the first semiconductor layer 31 and the second semiconductor layer 32. The light emitting layer 33 may include a material such as AlGaN or AlGaInN. For example, when the light emitting layer 33 has a structure in which quantum layers and well layers are alternately stacked in a multiple quantum well structure, the quantum layer may include a material such as AlGaN or AlGaInN, and the well layer may include a material such as GaN or AllnN.

The light emitting layer 33 may have a structure in which semiconductor materials having large band gap energy and semiconductor materials having small band gap energy are alternately stacked, and may include other Group III to V semiconductor materials according to the wavelength band of the emitted light. The light emitted by the light emitting layer 33 is not limited to light of a blue wavelength band, but the active layer 33 may also emit light of a red or green wavelength band in some cases.

The electrode layer 37 may be an ohmic connection electrode. However, the disclosure is not limited thereto, and it may be a Schottky connection electrode. The light emitting element ED may include at least one electrode layer 37. The light emitting element ED may include one or more electrode layers 37, but the disclosure is not limited thereto, and the electrode layer 37 may be omitted.

In the display device 10, when the light emitting element ED is electrically connected to an electrode or a connection electrode, the electrode layer 37 may reduce the resistance between the light emitting element ED and the electrode or connection electrode. The electrode layer 37 may include a conductive metal. For example, the electrode layer 37 may include at least one of aluminium (Al), titanium (Ti), indium (In), gold (Au), silver (Ag), ITO, IZO, or ITZO.

The insulating film 38 is arranged to surround the outer surfaces (e.g., outer peripheral or circumferential surfaces) of the plurality of semiconductor layers and electrode layers described above. For example, the insulating film 38 may be disposed to surround at least the outer surface of the light emitting layer 33, and may be formed to expose both ends of the light emitting element ED in the longitudinal direction. Further, in cross-sectional view, the insulating film 38 may have a top surface, which is rounded in a region adjacent to at least one end of the light emitting element ED.

The insulating film 38 may include a material having insulating properties, such as silicon oxide (SiOₓ), silicon nitride (SiNₓ), silicon oxynitride (SiOₓN_{y}), aluminium nitride (AlNₓ), and aluminium oxide (AlOₓ). It is illustrated in the drawing that the insulating film 38 is formed as a single layer, but the disclosure is not limited thereto. In one or more embodiments, the insulating film 38 may be formed in a multilayer structure having a plurality of layers stacked therein.

The insulating film 38 may function to protect the members. The insulating film 38 may prevent an electrical short circuit that is likely to occur at the light emitting layer 33 when an electrode to which an electrical signal is transmitted is in direct contact with the light emitting element ED. In addition, the insulating film 38 may prevent a decrease in luminous efficiency of the light emitting element ED.

Further, the insulating film 38 may have an outer surface which is surface-treated. The light emitting elements ED may be aligned in such a way of spraying the ink in which the light emitting elements ED are dispersed on the electrodes. Here, the surface of the insulating film 38 may be treated in a hydrophobic or hydrophilic manner in order to keep the light emitting elements ED in a dispersed state without aggregation with other light emitting elements ED adjacent in the ink.

Hereinafter, a manufacturing process of the display device 10 will be described with reference to other drawings.

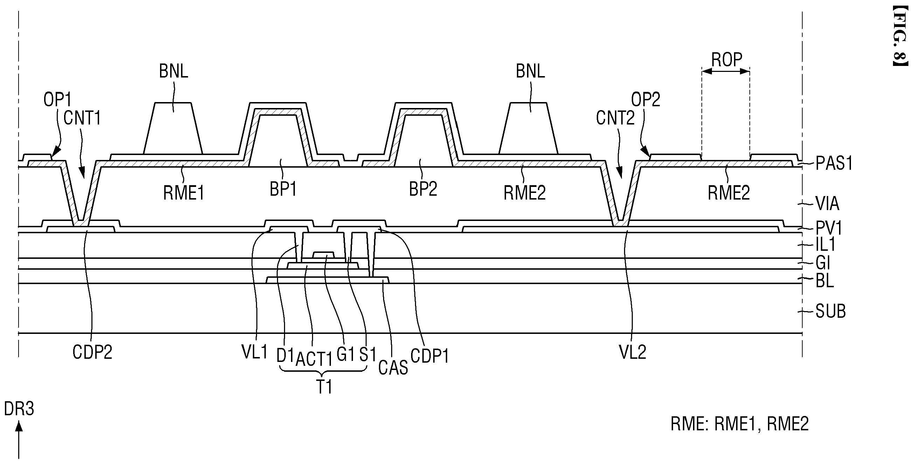

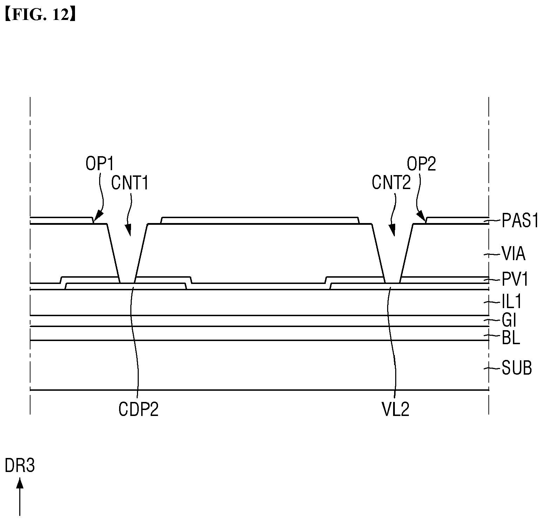

FIGS. 8 to 12 are cross-sectional views illustrating a process of manufacturing a display device according to one or more embodiments. In FIGS. 8 to 12, the structure of one sub-pixel SPXn of the display device 10 is shown in cross-sectional views, according to the formation order of the respective layers. FIGS. 8 to 11 illustrate a structure corresponding to the cross-sectional view of FIG. 4. FIG. 12 illustrates a structure corresponding to the cross-sectional view of FIG. 6. That is, FIGS. 8 to 11 illustrate cross-sectional views that traverse a portion where the light emitting elements ED are disposed and a portion where the plurality of contact holes CNT1 and CNT2 are formed. FIG. 12 illustrates a cross section that traverses in the second direction DR2 a portion where the plurality of contact holes CNT1 and CNT2 are formed. FIGS. 8 to 12 show an example of the formation order of the electrodes RME and the connection electrodes CNE. A process of forming each layer may be performed by a general patterning process. Hereinafter, a description of the formation method of each process will be briefly described, and the formation order will be mainly described.

First, referring to FIG. 8, the first substrate SUB is prepared, and the first to third conductive layers, the buffer layer BL, the first gate insulating layer GI, the first interlayer insulating layer IL1, the first passivation layer PV1, the via layer VIA, the bank patterns BP1 and BP2, the electrodes RME, the first insulating layer PAS1, and the bank layer BNL are formed on the first substrate SUB. Each of the first to third conductive layers disposed on the first substrate SUB may be formed by depositing a material, e.g., a metal material, constituting each layer, and patterning it using a mask. In addition, the buffer layer BL, the first gate insulating layer GI, the first interlayer insulating layer IL1, the first passivation layer PV1, and the via layer VIA disposed on the first substrate SUB may be formed by applying a material, e.g., an insulating material, constituting each layer, or if necessary, through a patterning process using a mask. The electrodes RME, the bank patterns BP1 and BP2, the first insulating layer PAS1, and the bank layer BNL disposed on the via layer VIA may also be formed through a similar process.

The first contact hole CNT1 and the second contact hole CNT2 penetrating the via layer VIA and the first passivation layer PV1 may be formed in the via layer VIA, and the first electrode RME1 and the second electrode RME2 may be formed to be connected to the third conductive layer through the contact holes CNT1 and CNT2, respectively. The first electrode RME1 may be connected to the second conductive pattern CDP2 through the first contact hole CNT1, and the second electrode RME2 may be connected to the second voltage line VL2 through the second contact hole CNT2.

The first insulating layer PAS1 may include the openings OP1 and OP2 disposed to overlap the contact holes CNT1 and CNT2 while exposing a portion of the top surfaces of the electrodes RME, and the separation portion ROP disposed not to overlap the contact holes CNT1 and CNT2 while exposing a portion of the top surfaces of the electrodes RME. The first opening OP1 may expose a portion of the first electrode RME1 disposed in the first contact hole CNT1, and the second opening OP2 may expose a portion of the second electrode RME2 disposed in the second contact hole CNT2. Although the drawing shows that the separation portion ROP exposes a portion of the top surface of the second electrode RME2, the separation portion ROP may also expose a portion of the top surface of the first electrode RME1 as well.

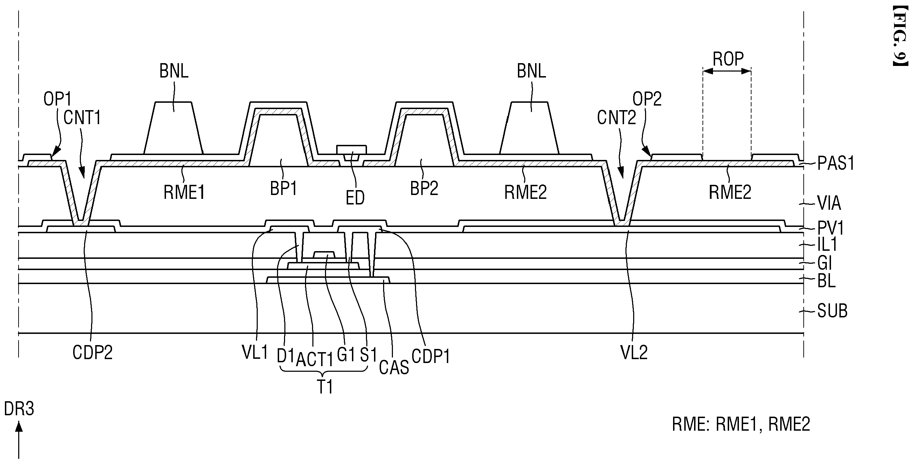

Next, referring to FIG. 9, the light emitting element ED is disposed on the first insulating layer PAS1. In one or more embodiments, the plurality of light emitting elements ED may be disposed above the electrode RME through an inkjet printing process. After the ink having the light emitting elements ED dispersed is sprayed into a region surrounded by the bank layer BNL, when an electric signal is applied to the electrodes RME, the light emitting elements ED in the ink may be placed above the electrodes RME while changing their own positions and orientation directions.

The electric signal applied to the electrodes RME may be applied through the third conductive layer. For example, a ground signal may be applied to the first electrode RME1 through the second conductive pattern CDP2, and an alignment signal may be applied to the second electrode RME2 through the second voltage line VL2. The electric signal applied to each electrode RME may generate an electric field between the electrodes RME, and the light emitting elements ED dispersed in the ink may be aligned above the electrodes RME by the electric field. When the light emitting elements ED are placed above the electrode RME, the ink is removed.

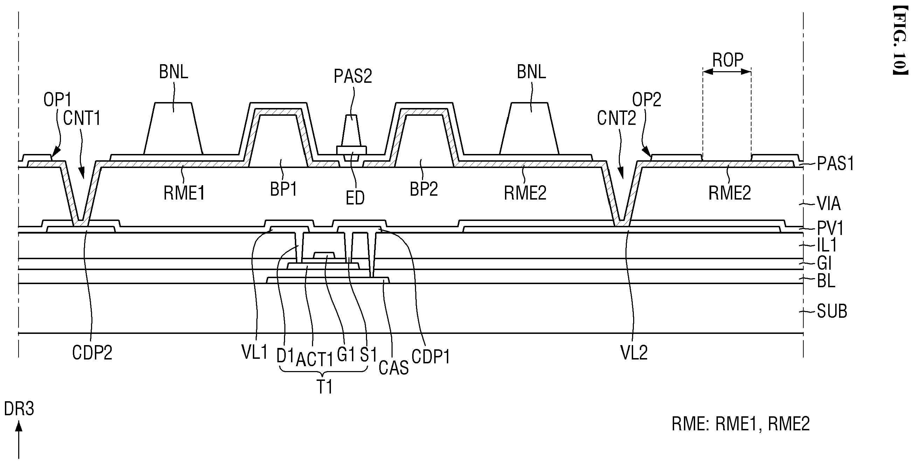

Next, referring to FIG. 10, the second insulating layer PAS2 disposed on the light emitting elements ED is formed. The second insulating layer PAS2 may cover and fix the light emitting elements ED. The second insulating layer PAS2 may be formed by coating an insulating material entirely on the first insulating layer PAS1 in the display area DPA and then patterning to expose both ends of the light emitting elements ED.

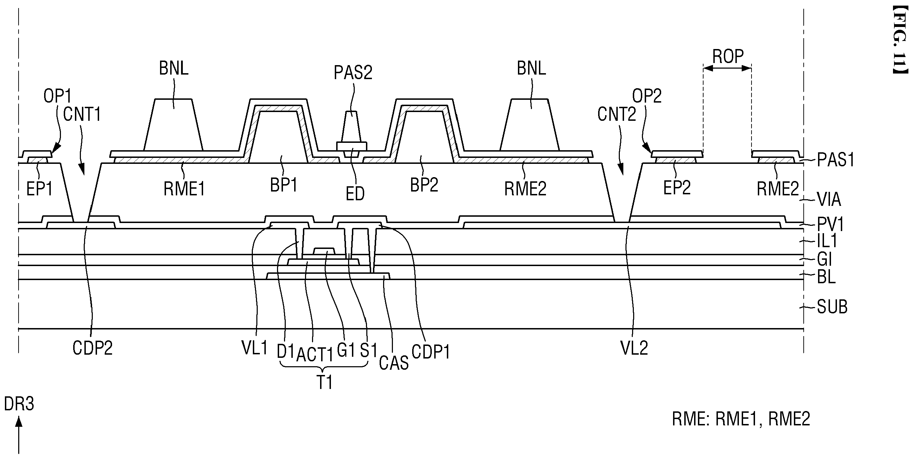

Next, referring to FIGS. 11 and 12, the electrodes RME are separated for each sub-pixel SPXn by removing a portion of the electrodes RME exposed in the openings OP1 and OP2 and the separation portion ROP of the first insulating layer PAS1. The electrodes RME disposed in the contact holes CNT1 and CNT2 are removed from the portions exposed by the first opening OP1 and the second opening OP2, and the electrodes RME may be separated from the dummy patterns EP1 and EP2 with the openings OP1 and OP2 interposed therebetween. The electrodes RME disposed in the separation portion ROP may also be removed to separate the dummy patterns EP1 and EP2 from electrodes RME of another sub-pixel SPXn.

According to one or more embodiments, the process of separating the electrodes RME may be performed by a wet etching process, and as shown in FIG. 11, at the sides in the first direction DR1 of the openings OP1 and OP2 and the separation portion ROP, an undercut may be formed in the electrode RME and the dummy patterns EP1 and EP2 below the first insulating layer PAS1. On the other hand, as shown in FIG. 12, at the sides in the second direction DR2 of the openings OP1 and OP2, the electrodes RME may be completely removed to expose the contact holes CNT1 and CNT2. As described above, the openings OP1 and OP2 may be formed to have a width greater than that of the electrodes RME in the second direction DR2, so that the electrodes RME may be completely separated from the dummy patterns EP1 and EP2, and the top surface of the via layer VIA near the contact holes CNT1 and CNT2 may be exposed.

Next, although not shown in the drawings, the plurality of connection electrodes CNE are formed to manufacture the display device 10. The connection electrodes CNE may be disposed on the first insulating layer PAS1 above the first electrode RME1 and the second electrode RME2, and may extend beyond the bank layer BNL up to the contact holes CNT1 and CNT2 of the sub-region SA.

Hereinafter, various embodiments of the display device 10 will be described with reference to other drawings.

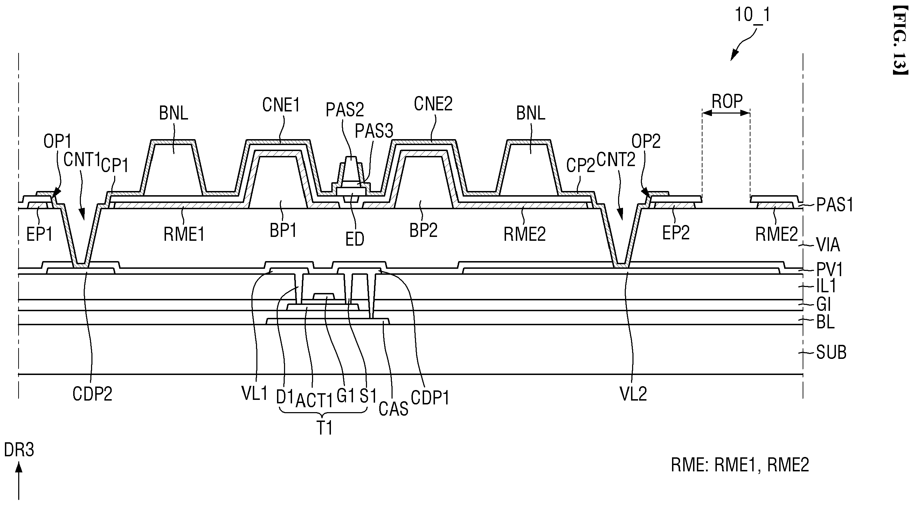

FIG. 13 is a cross-sectional view illustrating a portion of a display device according to one or more embodiments.

Referring to FIG. 13, a display device 10_1 according to one or more embodiments may further include a third insulating layer PAS3 disposed between the second insulating layer PAS2 and the light emitting element ED. The third insulating layer PAS3 may be formed prior to the second insulating layer PAS2 to fix the light emitting elements ED.

The third insulating layer PAS3 may be disposed below the second insulating layer PAS2 and have substantially the same shape as the second insulating layer PAS2. Although not shown in the drawing, the third insulating layer PAS3 may extend in the first direction DR1 between the bank patterns BP1 and BP2 to cover the plurality of light emitting elements ED. Both side surfaces of the third insulating layer PAS3 may be aligned with both side surfaces of the second insulating layer PAS2, respectively. The third insulating layer PAS3 may be formed by forming an insulating material to cover the plurality of light emitting elements ED and then patterning it in the same process as that of the second insulating layer PAS2. Accordingly, the pattern shape of the third insulating layer PAS3 in a plan view and cross-sectional view may be substantially the same as that of the second insulating layer PAS2.

In one or more embodiments, the third insulating layer PAS3 may include an inorganic insulating material or an organic insulating material, and when the second insulating layer PAS2 includes an organic insulating material, the third insulating layer PAS3 may include an inorganic insulating material. The third insulating layer PAS3 may be made of a material more similar to that of the first insulating layer PAS1 than the second insulating layer PAS2.

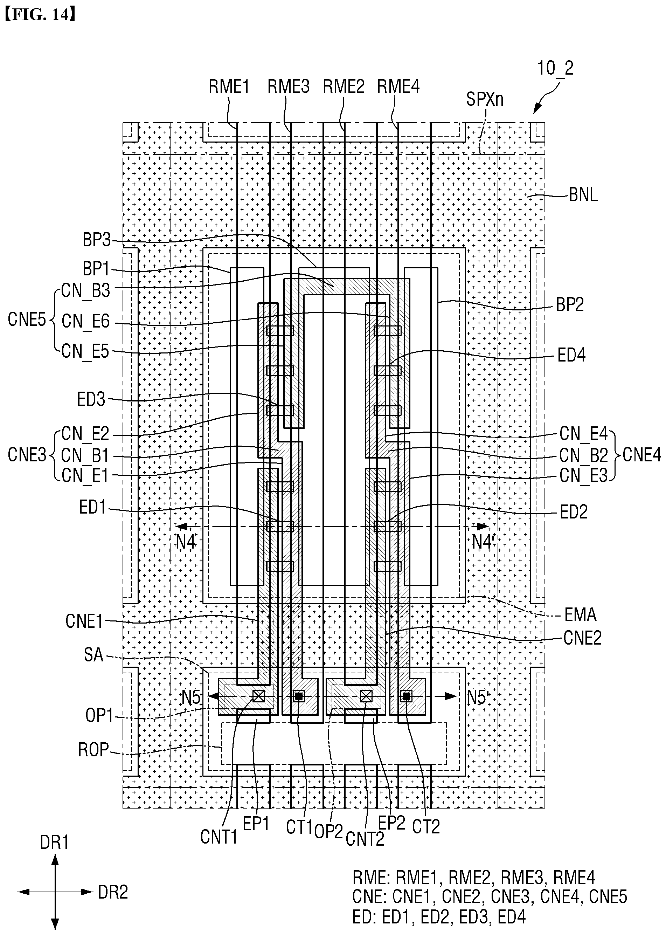

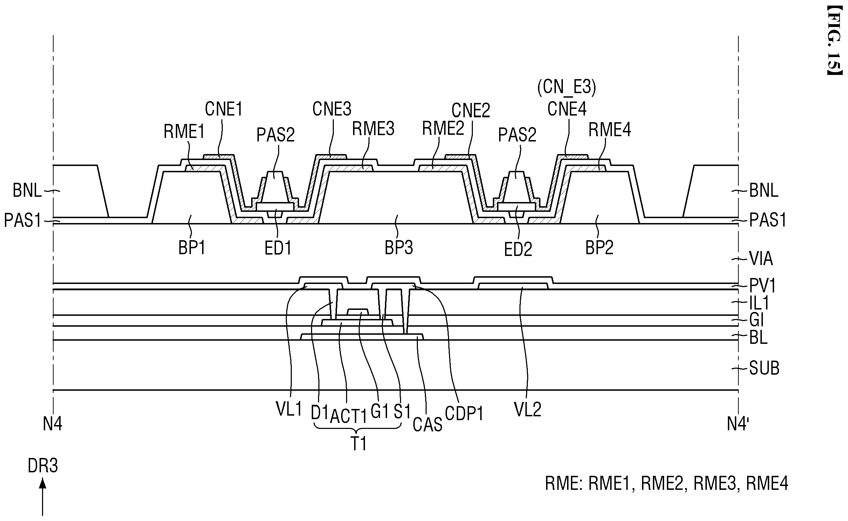

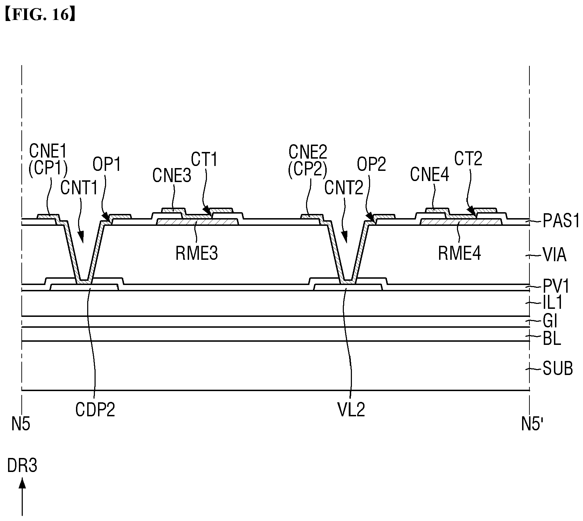

FIG. 14 is a plan view illustrating a sub-pixel of a display device according to one or more embodiments. FIG. 15 is a cross-sectional view taken along the line N4-N4' of FIG. 14. FIG. 16 is a cross-sectional view taken along the line N5-N5' of FIG. 14.

Referring to FIGS. 14 to 16, a display device 10_2 according to one or more embodiments may include a larger number of electrodes RME and a larger number of connection electrodes CNE, and the number of light emitting elements ED arranged in each sub-pixel SPXn may be increased. The embodiment differs from the embodiment of FIGS. 2 to 6 in that the arrangement of the electrodes RME and the connection electrodes CNE of each sub-pixel SPXn, and the bank patterns BP1, BP2, and BP3 are different. In the following description, redundant description will be omitted while focusing on differences.

The bank patterns BP1, BP2, and BP3 may further include a third bank pattern BP3 disposed between the first bank pattern BP1 and the second bank pattern BP2. The first bank pattern BP1 may be located on the left side with respect to the center of the emission area EMA, the second bank pattern BP2 may be located on the right side with respect to the center of the emission area EMA, and the third bank pattern BP3 may be located at the center of the emission area EMA. The width of the third bank pattern BP3 measured in the second direction DR2 may be greater than those of the first bank pattern BP1 and the second bank pattern BP2 measured in the second direction DR2. The gap between the bank patterns BP1, BP2, and BP3 in the second direction DR2 may be greater than the gap between the electrodes RME. Accordingly, at least portions of the electrodes RME may be arranged without overlapping the bank patterns BP1, BP2, and BP3.

The plurality of electrodes RME arranged for each sub-pixel SPXn may further include a third electrode RME3 and a fourth electrode RME4 in addition to a first electrode RME1 and a second electrode RME2.

The third electrode RME3 may be disposed between the first electrode RME1 and the second electrode RME2, and the fourth electrode RME4 may be spaced from the third electrode RME3 in the second direction DR2 with the second electrode RME2 interposed therebetween. The plurality of electrodes RME may be sequentially arranged in the order of the first electrode RME1, the third electrode RME3, the second electrode RME2, and the fourth electrode RME4 from the left side to the right side of the sub-pixel SPXn.

A first electrode RME1 may be disposed on the first bank pattern BP1, and a second electrode RME2 may be disposed on the third bank pattern BP3. The third electrode RME3 may be disposed on the third bank pattern BP3 to face the first electrode RME1. The fourth electrode RME4 may be disposed on the second bank pattern BP2 to face the second electrode RME2.

Among the plurality of electrodes RME, the first electrode RME1 and the second electrode RME2 may be spaced from the dummy patterns EP1 and EP2 with respect to the openings OP1 and OP2 of the first insulating layer PAS1 in the sub-region SA. The first contact hole CNT1 is disposed in the first opening OP1 between the first electrode RME1 and the first dummy pattern EP1, and the second contact hole CNT2 is disposed in the second opening OP2 between the second electrode RME2 and the second dummy pattern EP2. On the other hand, the third electrode RME3 and the fourth electrode RME4 may be spaced from a third electrode RME3 and a fourth electrode RME4 of another sub-pixel SPXn with respect to the separation portion ROP in the sub-region SA. The third electrode RME3 and the fourth electrode RME4 may not overlap the openings OP1 and OP2 and may not be subjected to a separation process for exposing the contact holes CNT1 and CNT2 penetrating the via layer VIA. A portion of the top surfaces of the third electrode RME3 and the fourth electrode RME4 may be exposed through electrode contact holes CT1 and CT2 to be in contact with the connection electrodes CNE.

The plurality of light emitting elements ED may be arranged between the bank patterns BP1, BP2, and BP3 or on different electrodes RME. Some of the light emitting elements ED may be arranged between the first bank pattern BP1 and the third bank pattern BP3, and some other light emitting elements ED may be arranged between the third bank pattern BP3 and the second bank pattern BP2. In accordance with one or more embodiments, the light emitting element ED may include a first light emitting element ED1 and a third light emitting element ED3 arranged between the first bank pattern BP1 and the third bank pattern BP3, and a second light emitting element ED2 and a fourth light emitting element ED4 arranged between the third bank pattern BP3 and the second bank pattern BP2. Each of the first light emitting element ED1 and the third light emitting element ED3 may be disposed above the first electrode RME1 and the third electrode RME3, and each of the second light emitting element ED2 and the fourth light emitting element ED4 may be disposed above the second electrode RME2 and the fourth electrode RME4. The first light emitting element ED1 and the second light emitting element ED2 may be arranged adjacent to the lower side of the emission area EMA of the corresponding sub-pixel SPXn or adjacent to the sub-region SA, and the third light emitting element ED3 and the fourth light emitting element ED4 may be arranged adjacent to the upper side of the emission area EMA of the corresponding sub-pixel SPXn.

However, the light emitting elements ED may not be classified depending on the arrangement positions in the emission area EMA, and may be classified depending on the connection relationship with the connection electrodes CNE to be described later. The light emitting elements ED may be in contact with different connection electrodes CNE at both ends thereof depending on the arrangement structure of the connection electrodes CNE, and may be classified into different light emitting elements ED depending on the types of the contact electrodes CNE to be in contact therewith.

The arrangement of the first insulating layer PAS1 may be similar to that described above with reference to the embodiment of FIGS. 2 to 6. The first insulating layer PAS1 may be disposed entirely in the sub-pixel SPXn and may include the plurality of openings OP1 and OP2 and the separation portion ROP. In addition, the first insulating layer PAS1 may further include the electrode contact holes CT1 and CT2 partially exposing the top surfaces of some of the electrodes RME.

The first insulating layer PAS1 may include a first electrode contact hole CT1 exposing a portion of the top surface of the third electrode RME3 in the sub-region SA, and a second electrode contact hole CT2 exposing a portion of the top surface of the fourth electrode RME4 in the sub-region SA. The first electrode contact hole CT1 may be disposed between the first opening OP1 and the second opening OP2, and the second electrode contact hole CT2 may be disposed in the second direction DR2 of the second opening OP2. The top surfaces of the third electrode RME3 and the fourth electrode RME4 exposed through the electrode contact holes CT1 and CT2 may be in contact with the connection electrodes CNE, respectively.

The plurality of connection electrodes CNE may further include, in addition to the first connection electrode CNE1 disposed on the first electrode RME1 and the second connection electrode CNE2 disposed on the second electrode RME2, a third connection electrode CNE3, a fourth connection electrode CNE4, and a fifth connection electrode CNE5 arranged across the plurality of electrodes RME.

Unlike the embodiment of FIGS. 2 to 6, the extension length of each of the first connection electrode CNE1 and the second connection electrode CNE2 in the first direction DR1 may be relatively short. The first connection electrode CNE1 and the second connection electrode CNE2 may be arranged on the lower side with respect to the center of the emission area EMA. The first connection electrode CNE1 and the second connection electrode CNE2 may be disposed over the emission area EMA and the sub-region SA of the corresponding sub-pixel SPXn, and may be in contact with the third conductive layer through the contact holes CNT1 and CNT2 formed in the sub-region SA, respectively. The first contact portion CP1 of the first connection electrode CNE1 may be in contact with the second conductive pattern CDP2 through the first contact hole CNT1 exposed in the first opening OP1, and the second contact portion CP2 of the second connection electrode CNE2 may be in contact with the second voltage line VL2 through the second contact hole CNT2 exposed in the second opening OP2.

The third connection electrode CNE3 may include a first extension portion CN_E1 disposed on the third electrode RME3, a second extension portion CN_E2 disposed on the first electrode RME1, and a first connection portion CN_B1 that connects the first extension portion CN_E1 to the second extension portion CN_E2. The first extension portion CN_E1 may be spaced from the first connection electrode CNE1 in the second direction DR2, and the second extension portion CN_E2 may be spaced from the first connection electrode CNE1 in the first direction DR1. The first extension portion CN_E1 may be disposed on the lower side of the emission area EMA of the corresponding sub-pixel SPXn, and the second extension portion CN_E2 may be disposed on the upper side of the emission area EMA. The first extension portion CN_E1 may be disposed over the emission area EMA and the sub-region SA to be in contact with the third electrode RME3 through the first electrode contact hole CT1 formed in the sub-region SA. The first connection portion CN_B1 may be disposed across the first electrode RME1 and the third electrode RME3 at the central portion of the emission area EMA. The third connection electrode CNE3 may have a shape substantially extending in the first direction DR1, and may have a shape that is bent in the second direction DR2 and extends in the first direction DR1 again.

The fourth connection electrode CNE4 may include a third extension portion CN_E3 disposed on the fourth electrode RME4, a fourth extension portion CN_E4 disposed on the second electrode RME2, and a second connection portion CN_B2 that connects the third extension portion CN_E3 to the fourth extension portion CN_E4. The third extension portion CN_E3 may face and may be spaced from the second connection electrode CNE2 in the second direction DR2, and the fourth extension portion CN_E4 may be spaced from the second connection electrode CNE2 in the first direction DR1. The third extension portion CN_E3 may be disposed on the lower side of the emission area EMA of the corresponding sub-pixel SPXn, and the fourth extension portion CN_E4 may be disposed on the upper side of the emission area EMA. The third extension portion CN_E3 may be disposed over the emission area EMA and the sub-region SA to be in contact with the fourth electrode RME4 through the second electrode contact hole CT2. The second connection portion CN_B2 may be disposed across the second electrode RME2 and the fourth electrode RME4 while being adjacent to the center of the emission area EMA. The fourth connection electrode CNE4 may have a shape substantially extending in the first direction DR1, and may have a shape that is bent in the second direction DR2 and extends in the first direction DR1 again.

The fifth connection electrode CNE5 may include a fifth extension portion CN_E5 disposed on the third electrode RME3, a sixth extension portion CN_E6 disposed on the fourth electrode RME4, and a third connection portion CN_B3 that connects the fifth extension portion CN_E5 to the sixth extension portion CN_E6. The fifth extension portion CN_E5 may face and may be spaced from the second extension portion CN_E2 of the third connection electrode CNE3 in the second direction DR2, and the sixth extension portion CN_E6 may face and may be spaced from the fourth extension portion CN_E4 of the fourth connection electrode CNE4 in the second direction DR2. Each of the fifth extension portion CN_E5 and the sixth extension portion CN_E6 may be arranged on the upper side of the emission area EMA, and the third connection portion CN_B3 may be disposed across the third electrode RME3, the second electrode RME2, and the fourth electrode RME4. The fifth connection electrode CNE5 may be disposed to surround the fourth extension portion CN_E4 of the fourth connection electrode CNE4 in a plan view.

The first connection electrode CNE1 and the second connection electrode CNE2 may be first type connection electrodes directly connected to the third conductive layer, and the third connection electrode CNE3 and the fourth connection electrode CNE4 may be second type connection electrodes in contact with the electrodes RME, e.g., the third electrode RME3 and the fourth electrode RME4, and the fifth connection electrode CNE5 may be a third type connection electrode not in contact with the electrodes RME and the third conductive layer.

The first connection electrode CNE1 and the second connection electrode CNE2 may be directly connected to the third conductive layer through the contact holes CNT1 and CNT2, respectively, while the third connection electrode CNE3 and the fourth connection electrode CNE4 may be connected to the third electrode RME3 and the fourth electrode RME4 through the electrode contact holes CT1 and CT2, respectively. The third connection electrode CNE3, the fourth connection electrode CNE4, and the fifth connection electrode CNE5 may be in contact with the light emitting elements ED without being directly connected to the third conductive layer, and may constitute an electrical connection circuit of the light emitting elements ED together with the first connection electrode CNE1 and the second connection electrode CNE2. In this case, the third electrode RME3 and the fourth electrode RME4 may be disposed in a non-floating state by being in contact with the third connection electrode CNE3 and the fourth connection electrode CNE4, respectively. However, the disclosure is not limited thereto, and the third electrode RME3 and the fourth electrode RME4 may also remain in a floating state without being in contact with the connection electrodes CNE.

As described above, the plurality of light emitting elements ED may be classified into different light emitting elements ED depending on the connection electrodes CNE to be in contact with both ends of the light emitting elements ED to correspond to the arrangement structure of the connection electrodes CNE.

The first light emitting element ED1 and the second light emitting element ED2 may have first ends in contact with the first type connection electrodes and second ends in contact with the second type connection electrodes. The first light emitting element ED1 may be in contact with the first connection electrode CNE1 and the third connection electrode CNE3, and the second light emitting element ED2 may be in contact with the second connection electrode CNE2 and the second connection electrode CNE4. The third light emitting element ED3 and the fourth light emitting element ED4 may have first ends in contact with the second type connection electrodes and second ends in contact with the third type connection electrodes. The third light emitting element ED3 may be in contact with the third connection electrode CNE3 and the fifth connection electrode CNE5, and the fourth light emitting element ED4 may be in contact with the fourth connection electrode CNE4 and the fifth connection electrode CNE5.

The plurality of light emitting elements ED may be connected in series through the plurality of connection electrodes CNE. Because the display device 10_5 according to the illustrated embodiment includes a larger number of light emitting elements ED for each sub-pixel SPXn and the light emitting elements ED are connected in series, the light emission amount per unit area may be further increased.

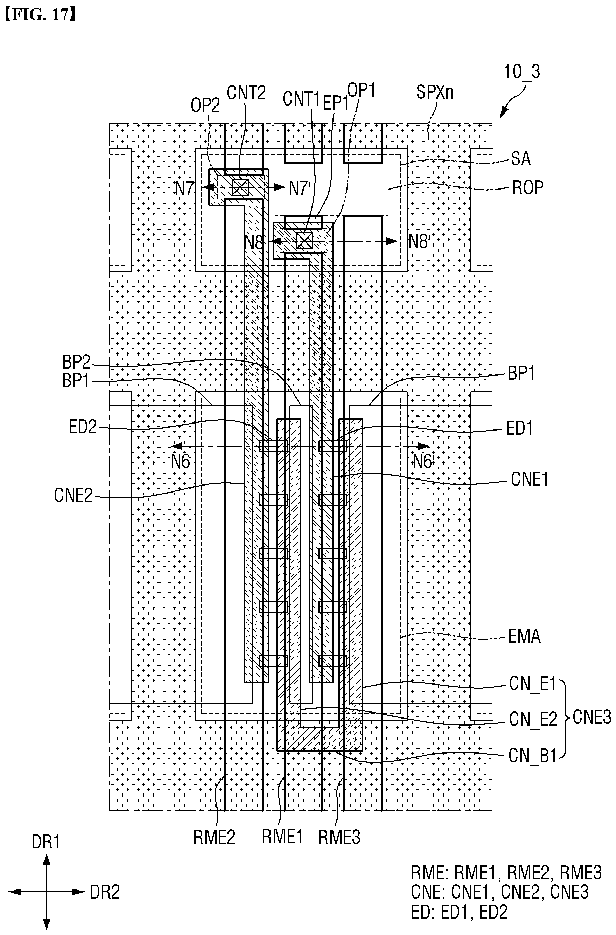

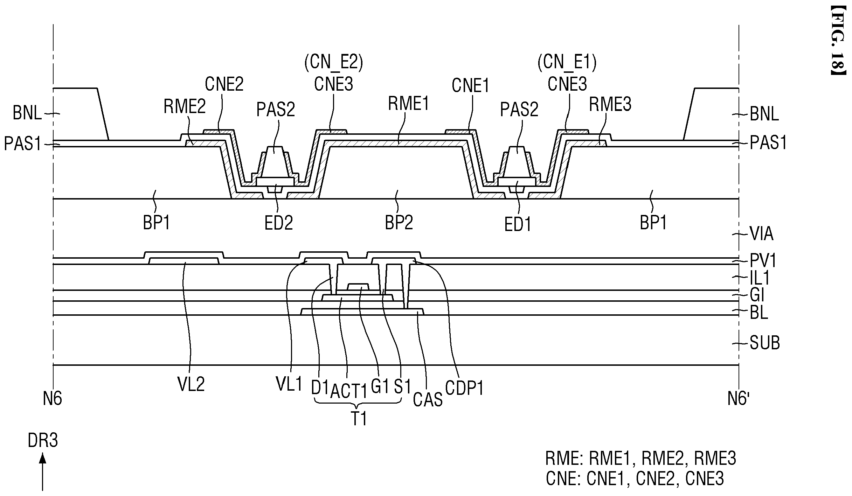

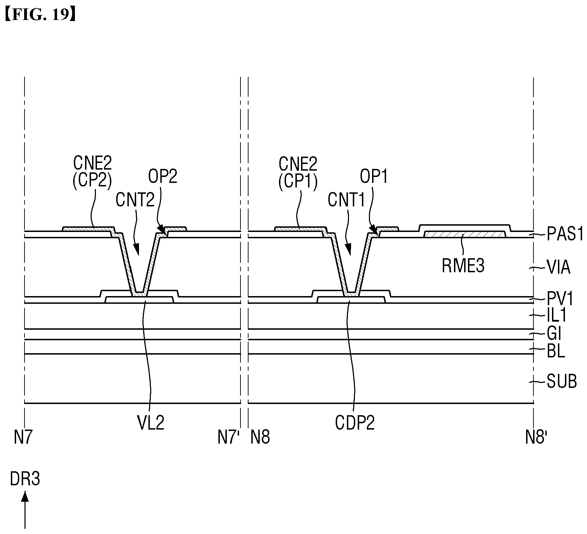

FIG. 17 is a plan view illustrating a sub-pixel of a display device according to one or more embodiments. FIG. 18 is a cross-sectional view taken along the line N6-N6' of FIG. 17. FIG. 19 is a cross-sectional view taken along the lines N7-N7' and N8-N8' of FIG. 17.

Referring to FIGS. 17 to 19, a display device 10_3 according to one or more embodiments may be different from those of the above-described embodiments in the structures of the electrode RME, the connection electrode CNE, and the bank patterns BP1 and BP2.

The plurality of bank patterns BP1 and BP2 may have different widths measured in the second direction DR2, and any one of the bank patterns BP1 and BP2 may be disposed across the sub-pixels SPXn adjacent in the second direction DR2. For example, the bank patterns BP1 and BP2 may include the first bank pattern BP1 disposed over the emission areas EMA of different sub-pixels SPXn, and the second bank pattern BP2 disposed between the first bank patterns BP1 in the emission area EMA of each sub-pixel SPXn.

The second bank pattern BP2 is disposed at the center of the emission areas EMA, and the first bank patterns BP1 are disposed to be spaced from the second bank pattern BP2 interposed therebetween. The first bank pattern BP1 and the second bank pattern BP2 may be alternately disposed along the second direction DR2. The light emitting elements ED may be disposed between the first bank pattern BP1 and the second bank pattern BP2 that are spaced from each other.

The first bank pattern BP1 and the second bank pattern BP2 may have the same length in the first direction DR1, but may have different widths measured in the second direction DR2. In the bank layer BNL, a portion extending in the first direction DR1 may overlap the first bank pattern BP1 in the thickness direction. The bank patterns BP1 and BP2 may be disposed in an island-like pattern on the entire surface of the display area DPA.

The plurality of electrodes RME includes the first electrode RME1, the second electrode RME2, and the third electrode RME3. The first electrode RME1 is disposed at the center of the emission area EMA, the second electrode RME2 is disposed on the left side of the first electrode RME1, and the third electrode RME3 is disposed on the right side of the first electrode RME1.

The first electrode RME1 may be disposed on the second bank pattern BP2, and portions of the second electrode RME2 and the third electrode RME3 may be disposed respectively on the first bank patterns BP1 different from each other. Each of the electrodes RME may be disposed on at least an inclined side surface of each of the bank patterns BP1 and BP2. The first electrode RME1 may have a larger width in the second direction DR2 than the second bank pattern BP2, and the second electrode RME2 and the third electrode RME3 may have a smaller width in the second direction DR2 than the first bank pattern BP1.

The first electrode RME1 may extend in the first direction DR1 but may be spaced from the first dummy pattern EP1 with respect to the first opening OP1 in the sub-region SA. In addition, the first dummy pattern EP1 may be spaced from a first electrode RME1 of another sub-pixel SPXn adjacent in the first direction DR1 with respect to the separation portion ROP. That is, the first electrode RME1 may be first formed in a shape extending in one direction, and then during a process of exposing the first contact hole CNT1, may be separated in the separation portion ROP and the first opening OP1 to form the first electrode RME1 and the first dummy pattern EP1 disposed for each sub-pixel SPXn. The first dummy pattern EP1 may be disposed between the first opening OP1 and the separation portion ROP.

The second electrode RME2 may extend in the first direction DR1 but may be spaced from a second electrode RME2 of another sub-pixel SPXn adjacent in the first direction DR1 with respect to the second opening OP2 in the sub-region SA. Unlike the first electrode RME1, the second electrode RME2 may not be separated in the separation portion ROP. The plurality of second electrodes RME2 may be separated only in the second opening OP2 during the process of exposing the second contact hole CNT2 to be separately disposed for each sub-pixel SPXn. The second electrodes RME2 of different sub-pixels SPXn may be spaced from each other in the first direction DR1 with the second opening OP2 of the sub-region SA interposed therebetween.

The third electrode RME3 may extend in the first direction DR1 but may be spaced from a third electrode RME3 of another sub-pixel SPXn in the separation portion ROP of the sub-region SA. Unlike the first electrode RME1 and the second electrode RME2, the third electrode RME3 may be disposed not to overlap the openings OP1 and OP2, and may be separated with respect to the separation portion ROP during a process for exposing the contact holes CNT1 and CNT2 to form the third electrodes RME3 disposed for each sub-pixel SPXn. The third electrode RME3 may be disposed from the emission area EMA to the separation portion ROP of the sub-region SA.

The plurality of light emitting elements ED may be disposed on different electrodes RME between different bank patterns BP1 and BP2. The light emitting element ED may include a first light emitting element ED1 whose both ends are respectively disposed on the first electrode RME1 and the third electrode RME3, and a second light emitting element ED2 whose both ends are respectively disposed on the first electrode RME1 and the second electrode RME2. The first light emitting elements ED1 may be disposed on the right side with respect to the first electrode RME1, and the second light emitting elements ED2 may be disposed on the left side with respect to the first electrode RME1.

The plurality of connection electrodes CNE (CNE1, CNE2, CNE3) may include a first connection electrode CNE1 and a second connection electrode CNE2 that are first type connection electrodes, and a third connection electrode CNE3 that is a third type connection electrode.

The first connection electrode CNE1 may have a shape extending in the first direction DR1 and may be disposed on the first electrode RME1. A portion of the first connection electrode CNE1 disposed on the second bank pattern BP2 may overlap the first electrode RME1, and may extend in the first direction DR1 therefrom to be disposed up to a sub-region SA of another sub-pixel SPXn positioned above the emission area EMA beyond the bank layer BNL. The first contact portion CP1 of the first connection electrode CNE1 may be in contact with the third conductive layer through the first contact hole CNT1 in the sub-region SA.

The second connection electrode CNE2 may have a shape extending in the first direction DR1 and may be disposed on the second electrode RME2. A portion of the second connection electrode CNE2 disposed on the first bank pattern BP1 may overlap the second electrode RME2, and may extend in the first direction DR1 therefrom to be disposed up to a sub-region SA of another sub-pixel SPXn positioned above the emission area EMA beyond the bank layer BNL. The second contact portion CP2 of the second connection electrode CNE2 may be in contact with the third conductive layer through the second contact hole CNT2 in the sub-region SA.

The third connection electrode CNE3 may include extension portions CN_E1 and CN_E2 extending in the first direction DR1 and a first connection portion CN_B1 connecting the extension portions CN_E1 and CN_E2. The first extension portion CN_E1 is disposed above the third electrode RME3 in the emission area EMA, and the second extension portion CN_E2 is disposed above the first electrode RME1 in the emission area EMA. The first connection portion CN_B1 may extend in the second direction DR2 above the bank layer BNL disposed below the emission area EMA to connect the first extension portion CN_E1 to the second extension portion CN_E2. The third connection electrode CNE3 may be disposed on the emission area EMA and the bank layer BNL, and may not be connected to the third electrode RME3. The third electrode RME3 may be disposed in a floating state that is not electrically connected to the connection electrode CNE and the light emitting element ED. The first light emitting element ED1 and the second light emitting element ED2 may be connected in series only through the third connection electrode CNE3.

In the illustrated embodiment, the third electrode RME3 may remain in a floating state without being connected to the connection electrode CNE3, but may be connected to another adjacent electrode RME in one or more embodiments. For example, the third electrode RME3 may be connected to a second electrode RME2 disposed in another sub-pixel SPXn adjacent in the second direction DR2. In this case, the third electrode RME3 may have a shape branched from the second electrode RME2 of the adjacent sub-pixel SPXn, and only the first electrode RME1 may be separated in the separation portion ROP of the sub-region SA.

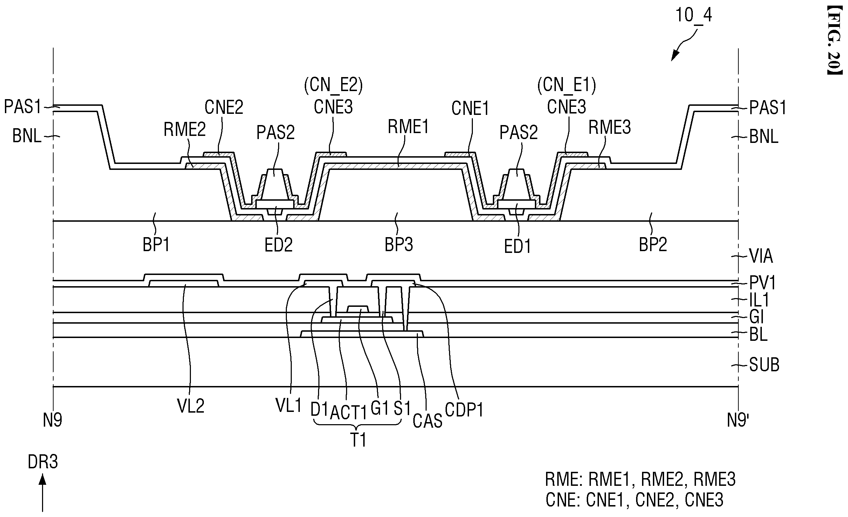

FIG. 20 is a cross-sectional view illustrating a portion of a display device according to one or more embodiments.

Referring to FIG. 20, in a display device 10_4 according to one or more embodiments, the bank patterns BP1 and BP2 and the bank layer BNL may be integrally formed, and the first insulating layer PAS1 may be disposed on the bank patterns BP1 and BP2 and the bank layer BNL.

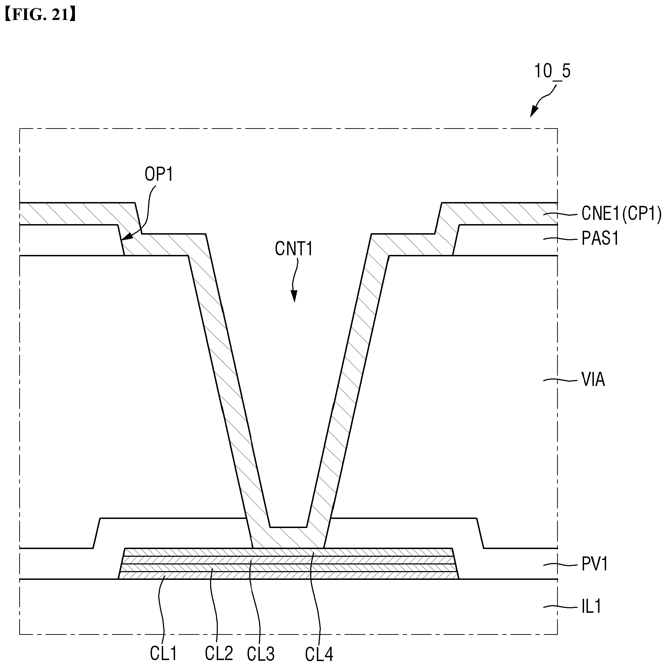

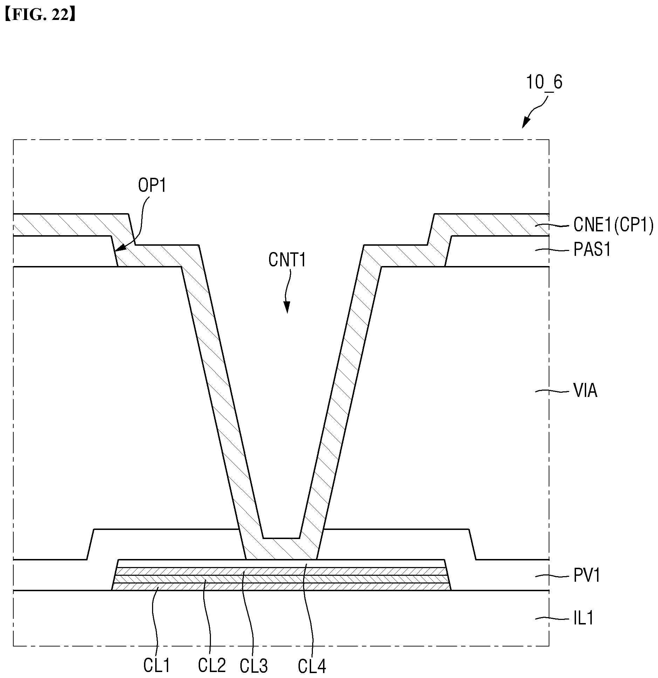

FIGS. 21 and 22 are cross-sectional views illustrating a third conductive layer of a display device according to one or more embodiments.

Referring to FIGS. 21 and 22, in display devices 10_5 and 10_6 according to one or more embodiments, the third conductive layer may be formed of a plurality of layers CL1, CL2, CL3, and CL4. As described above, the third conductive layer may be formed as a single layer or multiple layers made of any one of molybdenum (Mo), aluminium (Al), chromium (Cr), gold (Au), titanium (Ti), nickel (Ni), neodymium (Nd), and copper (Cu), or an alloy thereof. The display devices 10_5 and 10_6 have a structure in which the connection electrodes CNE are in direct contact with the third conductive layer, and a process of removing the electrode RME connected to the third conductive layer is performed during the manufacturing process. The display devices 10_5 and 10_6 may have a structure in which a plurality of layers are stacked in consideration of damage to the third conductive layer.

In the display device 10_5 of FIG. 21, the third conductive layer may have a structure in which a first layer CL1, a second layer CL2, a third layer CL3, and a fourth layer CL4 are sequentially stacked. Herein, the first layer CL1 and the third layer CL3 may include the same material, and the second layer CL2 and the fourth layer CL4 may include the same material. For example, the third conductive layer may have a stacked structure of Ti/Cu/Ti/Cu. In the process of removing the electrodes RME disposed in the contact holes CNT1 and CNT2, even if the fourth layer CL4 and the third layer CL3, which are upper layers among the first to fourth layers CL1, CL2, CL3 and CL4, are partially damaged, the first layer CL1 and the second layer CL2 therebelow may be protected. When the connection electrode CNE is formed in a subsequent process, at least the first layer CL1 and the second layer CL2 among the plurality of layers may remain, thereby preventing electrical connection failure.

In the display device 10_6 of FIG. 22, the third conductive layer may have a structure in which a first layer CL1, a second layer CL2, a third layer CL3, and a fourth layer CL4 are sequentially stacked. Herein, the first layer CL1 and the third layer CL3 may include the same material, and the second layer CL2 and the fourth layer CL4 may include a material different from that of the first layer CL1. In one or more embodiments, the fourth layer CL4 may include the same material as the connection electrode CNE. For example, the third conductive layer may have a stacked structure of Ti/Cu/Ti/ITO. As the fourth layer CL4, which is the uppermost layer of the third conductive layer, includes a material different from that of the first to third layers CL1, CL2, and CL3, the first to third layers CL1, CL2, and CL3 may be protected by the fourth layer CL4 during the process of removing the electrode RME. In addition, as the fourth layer CL4 includes the same material as the connection electrode CNE, there is an advantage that smoother contact between the third conductive layer and the connection electrode CNE is possible.

In concluding the detailed description, those skilled in the art will appreciate that many variations and modifications may be made to the embodiments without substantially departing from the principles of the disclosure. Therefore, the disclosed embodiments are used in a generic and descriptive sense only and not for purposes of limitation.

## Claims

1. A display device comprising:
a conductive layer comprising a voltage line and a conductive pattern on a substrate;
a via layer on the conductive layer and including a plurality of contact holes exposing a portion of the conductive layer;
a first electrode and a second electrode spaced from each other on the via layer;
a first insulating layer on the first electrode and the second electrode and including a plurality of openings exposing the plurality of contact holes;
light emitting elements on the first electrode and the second electrode on the first insulating layer; and
a first connection electrode on the first electrode and in contact with the light emitting element, and a second connection electrode on the second electrode and in contact with the light emitting element,
wherein the first connection electrode is in direct contact with the conductive pattern through a first opening exposing a first contact hole of the plurality of contact holes, and
wherein the second connection electrode is in direct contact with the voltage line through a second opening exposing a second contact hole of the plurality of contact holes.

2. The display device of claim 1, further comprising a first dummy pattern spaced from the first electrode with the first contact hole interposed therebetween, and
a second dummy pattern spaced from the second electrode with the second contact hole interposed therebetween,
wherein a portion of the first insulating layer is on the first dummy pattern and the second dummy pattern.

3. The display device of claim 2, wherein the first electrode and the second electrode are spaced from the first dummy pattern and the second dummy pattern in one direction, respectively, and
one sides of the first electrode and the second electrode facing the first dummy pattern and the second dummy pattern are spaced from one side in the one direction of the openings more inward than the first insulating layer.

4. The display device of claim 1, wherein a first width of the first electrode and the second electrode measured in one direction is smaller than a second width of the first opening and the second opening measured in the one direction.

5. The display device of claim 4, wherein the first connection electrode comprises a first contact portion having a width measured in the one direction greater than the first width and located on the first contact hole, and
the second connection electrode comprises a second contact portion having a width measured in the one direction greater than the first width and located on the second contact hole.

6. The display device of claim 5, wherein the first contact portion and the second contact portion are directly on the via layer around the first contact hole and the second contact hole, respectively.

7. The display device of claim 5, wherein a width of each of the first contact portion and the second contact portion measured in the one direction is greater than the second width.

8. The display device of claim 1, further comprising a bank layer around an emission area in which the light emitting elements are located on the first insulating layer, and
a sub-region at one side of the emission area,
wherein the first contact hole and the second contact hole are in the sub-region, and
wherein each of the first connection electrode and the second connection electrode is located over the emission area and the sub-region.

9. The display device of claim 8, wherein the first insulating layer further comprises a separation portion in the sub-region and exposes a top surface of the via layer.

10. The display device of claim 1, further comprising a second insulating layer on the light emitting elements without covering both sides of the light emitting elements.

11. The display device of claim 10, further comprising a third insulating layer between the second insulating layer and the light emitting element,
wherein both sides of the third insulating layer are parallel to both sides of the second insulating layer.

12. The display device of claim 1, wherein the conductive layer comprises:
a first layer,
a second layer on the first layer and comprising a material different from the first layer,
a third layer on the second layer and comprising a same material as the first layer, and
a fourth layer on the third layer.

13. The display device of claim 12, wherein the fourth layer comprises a same material as the first and second connection electrodes.

14. A display device comprising:
an emission area and a sub-region at one side of the emission area in a first direction;
first and second electrodes extending in the first direction and spaced from each other in a second direction, the first and second electrodes being in the emission area and the sub-region;
a first insulating layer on the first electrode and the second electrode and including a plurality of openings in the sub-region;
a plurality of light emitting elements on the first electrode and the second electrode in the emission area;
a first connection electrode on the first electrode in the emission area and the sub-region and in contact with the light emitting element; and
a second connection electrode on the second electrode in the emission area and the sub-region and in contact with the light emitting element,
wherein the first connection electrode comprises a first contact portion on a first contact hole exposed in a first opening of the first insulating layer, and
wherein the second connection electrode comprises a second contact portion on a second contact hole exposed in a second opening of the first insulating layer.

15. The display device of claim 14, further comprising a first dummy pattern spaced from the first electrode in the first direction with the first opening interposed therebetween, and
a second dummy pattern spaced from the second electrode in the first direction with the second opening interposed therebetween.

16. The display device of claim 15, wherein the first opening and the second opening have a width measured in the second direction greater than a width of the first electrode and the second electrode measured in the second direction.

17. The display device of claim 15, wherein the first contact portion and the second contact portion have widths measured in the first direction and the second direction greater than widths of the first opening and the second opening measured in the first direction and the second direction, respectively.

18. The display device of claim 15, wherein the first connection electrode has a shape extending in the first direction,
wherein the first contact portion has a shape protruding from the first opening in the second direction,
wherein the second connection electrode has a shape extending in the first direction, and
wherein the second contact portion has a shape protruding from the second opening in the second direction.

19. The display device of claim 14, further comprising a third electrode spaced from the second electrode in the second direction with the first electrode interposed therebetween, and
a first dummy pattern spaced from the first electrode in the first direction with the first opening interposed therebetween,
wherein the third electrode extends from the emission area to a separation portion in the sub-region, and
the dummy pattern is located between the separation portion and the first opening.

20. The display device of claim 19, wherein the light emitting element comprises a first light emitting element between the first electrode and the third electrode, and a second light emitting element on the first electrode and the second electrode,
wherein the display device further comprises a third connection electrode on the third electrode and the first electrode, and in contact with one end of each of the first light emitting element and the second light emitting element.

21. The display device of claim 14, further comprising:
a third electrode between the first electrode and the second electrode; and
a fourth electrode spaced from the third electrode in the second direction with the second electrode interposed therebetween,
wherein the light emitting element comprises a first light emitting element, a second light emitting element, a third light emitting element, and a fourth light emitting element,
wherein the first light emitting element and the third light emitting element are on the first electrode and the third electrode, and
wherein the second light emitting element and the fourth light emitting element are on the second electrode and the fourth electrode.

22. The display device of claim 21, further comprising:
a third connection electrode spaced from the first connection electrode and disposed across the first electrode and the third electrode;
a fourth connection electrode spaced from the second connection electrode and disposed across the second electrode and the fourth electrode; and
a fifth connection electrode spaced from the third connection electrode and the fourth connection electrode and disposed across the third electrode and the fourth electrode.

23. The display device of claim 22, wherein the first connection electrode is in contact with the first light emitting element,
wherein the second connection electrode is in contact with the second light emitting element,
wherein the third connection electrode is in contact with the first light emitting element and the third light emitting element,
wherein the fourth connection electrode is in contact with the second light emitting element and the fourth light emitting element, and
wherein the fifth connection electrode is in contact with the third light emitting element and the fourth light emitting element.

24. The display device of claim 22, wherein the third connection electrode comprises a first extension portion spaced from the first connection electrode in the second direction, a second extension portion spaced from the first connection electrode in the first direction, and a first connection portion connecting the first extension portion to the second extension portion,
wherein the fourth connection electrode comprises a third extension portion spaced from the second connection electrode in the second direction, a fourth extension portion spaced from the second connection electrode in the first direction, and a second connection portion connecting the third extension portion to the fourth extension portion, and
wherein the fifth connection electrode comprises a fifth extension portion spaced from the second extension portion in the second direction, a sixth extension portion spaced from the fourth extension portion in the second direction, and a third connection portion connecting the fifth extension portion to the sixth extension portion.

25. The display device of claim 22, wherein the third connection electrode is located over the emission area and the sub-region, and is in contact with the third electrode through a first electrode contact hole penetrating the first insulating layer in the sub-region, and
wherein the fourth connection electrode is located over the emission area and the sub-region, and is in contact with the fourth electrode through a second electrode
contact hole penetrating the first insulating layer in the sub-region.
